# EUROPEAN PATENT APPLICATION

(11) **EP 4 445 762 A1**
(43) Date of publication of application: **16.10.2024**
(21) Application number: 21967257.3
(22) Date of filing: 10.12.2021
(51) Int. Cl.: A24F 40/40

(54) **POWER SOURCE UNIT OF AEROSOL GENERATING DEVICE**

(71) Applicant: Japan Tobacco Inc., Tokyo 105-6927 (JP)
(72) Inventor: MARUBASHI, Keiji, Tokyo 130-8603 (JP); KITAHARA, Minoru, Tokyo 130-8603 (JP)
(74) Representative: Hoffmann Eitle
(86) International application number: PCT/JP2021/045589
(87) International publication number: WO 2023/105765

(57) **Abstract**

Provided is a power source unit for an aerosol generating device, the power source unit being able to suitably handle a large amount of power inside a circuit board. This power source unit 100 comprises a power source ba, a switch Q1 that can adjust the power provided from the power source ba to a liquid heater, and a main board 20 to which the switch Q1 is mounted. The main board 20 comprises: a first layer LA1 that is the surface layer to which the switch Q1 is mounted; a second layer LA2 that is different from the first layer LA1; a via VA16 that passes through the first layer LA1 and is connected to the switch Q1; a via VA17 that passes through the first layer LA1 and is disposed away from the via VA16; and a conduction pattern PT11 that is provided to the second layer LA2 and connects the via VA16 and the via VA17.

## Description

### TECHNICAL FIELD

The present invention relates to a power supply unit of an aerosol generating device.

### BACKGROUND ART

In order to further enhance flavor of an aerosol, a heating-type tobacco including a plurality of heaters is known. For example, Patent Literature 1 discloses a smoking apparatus including a liquid evaporator and a cigarette heater. Patent Literature 2 discloses a cigarette-type electronic cigarette heater assembly including a smoking steam generation unit including a first heat generation heater for heating a part of a cigarette inserted therein to generate smoking steam, and a smoke emitting steam generation unit including a second heat generation heater for heating a liquid substance when a cigarette is inhaled to generate smoke emitting steam.

### CITATION LIST

### PATENT LITERATURE

Patent Literature 1: JP2017-511703A
Patent Literature 2: JP2020-527955A

### SUMMARY OF INVENTION

### TECHNICAL PROBLEM

In an aerosol generating device, since it is necessary to supply electric power to a heater, heating power generated from a power supply tends to be large electric power. There is room for consideration regarding how to handle such large electric power in a circuit substrate.

An object of the present invention is to provide a power supply unit for an aerosol generating device capable of appropriately handling large electric power in a circuit substrate.

### SOLUTION TO PROBLEM

A power supply unit of an aerosol generating device according to an embodiment of the present invention includes:
a power supply;
a first switch configured to adjust electric power to be supplied from the power supply to an atomizer that atomizes an aerosol source; and
a circuit substrate on which the first switch is mounted, in which the circuit substrate includes:
   a first layer that is a front layer on which the first switch is mounted,
   a second layer that is different from the first layer,
   a first via that penetrates the first layer and is connected to the first switch,
   a second via that penetrates the first layer or the second layer and is spaced apart from the first via, and
   a first conductive pattern that is provided on the second layer and connects the first via and the second via.

### ADVANTAGEOUS EFFECTS OF INVENTION

According to the present invention, large electric power may be appropriately handled in the circuit substrate.

### BRIEF DESCRIPTION OF DRAWINGS

[FIG. 1] FIG. 1 is a perspective view for an aerosol generating device 200.
[FIG. 2] FIG. 2 is another perspective view of the aerosol generating device 200.
[FIG. 3] FIG. 3 is an exploded perspective view of the aerosol generating device 200.
[FIG. 4] FIG. 4 is a left side view of an internal unit 2A.
[FIG. 5] FIG. 5 is a right side view of the internal unit 2A.
[FIG. 6] FIG. 6 is a perspective view showing a configuration of a heating unit 60 and a circuit unit 70 of the internal unit 2A.
[FIG. 7] FIG. 7 is a view showing a front surface 201 of a main substrate 20.
[FIG. 8] FIG. 8 is a view showing a back surface 202 of the main substrate 20.
[FIG. 9] FIG. 9 is a diagram showing a schematic configuration of a circuit provided in the main substrate 20.
[FIG. 10] FIG. 10 is a circuit diagram showing electronic components related to an operation in a heating mode and extracted from the circuit shown in FIG. 9.
[FIG. 11] FIG. 11 is a circuit diagram showing electronic components related to a heating control of a sheet heater HTR and a liquid heater, a driving control of a vibration motor 13, and a driving control of an LED 21D and extracted from the circuit shown in FIG. 9.
[FIG. 12] FIG. 12 is a circuit diagram showing electronic components related to restart of an MCU 6 and extracted from the circuit shown in FIG. 9.
[FIG. 13] FIG. 13 is a side view of the main substrate 20 as viewed from a right side surface 20SR side.
[FIG. 14] FIG. 14 is a front view of a second layer LA2 as viewed from a front side.

### DESCRIPTION OF EMBODIMENTS

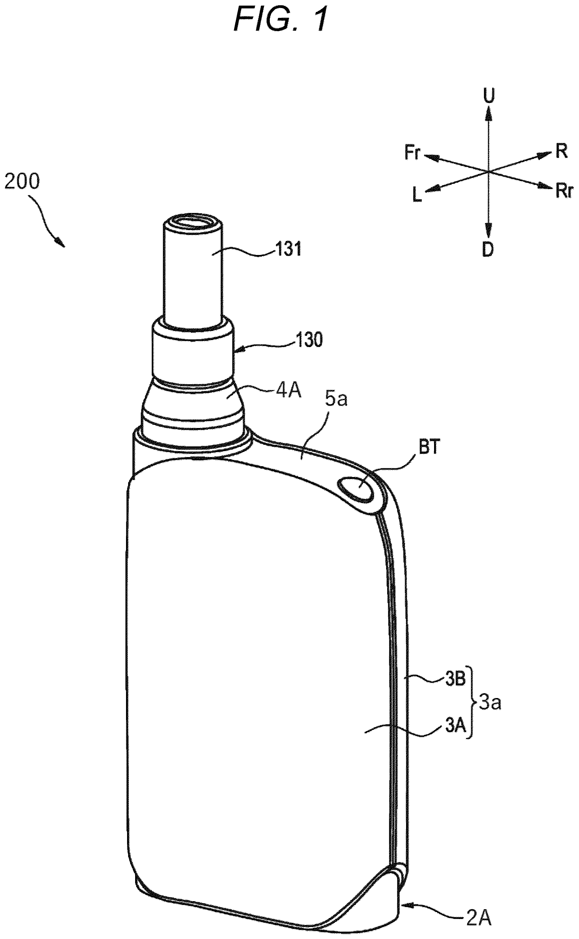

Hereinafter, a power supply unit for an aerosol generating device according to an embodiment of the present invention will be described. First, an aerosol generating device including a power supply unit of the present embodiment will be described with reference to FIGs. 1 to 8.

### (Aerosol Generating Device)

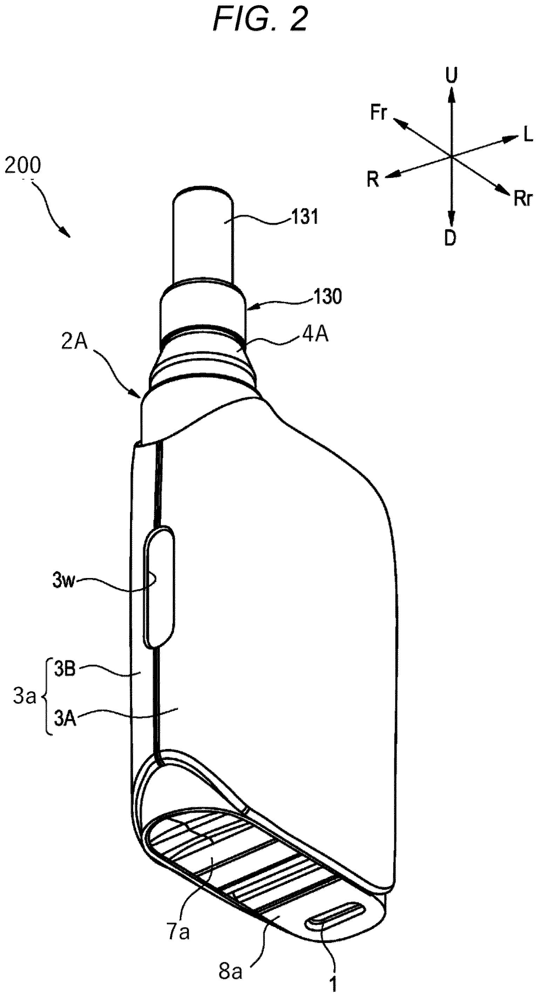

An aerosol generating device 200 is a device for generating flavored aerosol without combustion and inhaling the generated aerosol. The aerosol generating device 200 preferably has a size that fits in hands, and for example, as shown in FIGs. 1 and 2, has a rounded, substantially rectangular parallelepiped shape. The shape of the aerosol generating device 200 is not limited thereto, and may be a bar shape, an egg shape, or the like. In the following description, three directions orthogonal to one another in the aerosol generating device 200 are referred to as an upper-lower direction, a front-rear direction, and a left-right direction in descending order of length. In the following description, for convenience, as shown in FIGs. 1 to 8, front, rear, left, right, upper, and lower are defined, a front side is denoted by Fr, a rear side is denoted by Rr, a left side is denoted by L, a right side is denoted by R, an upper side is denoted by U, and a lower side is denoted by D.

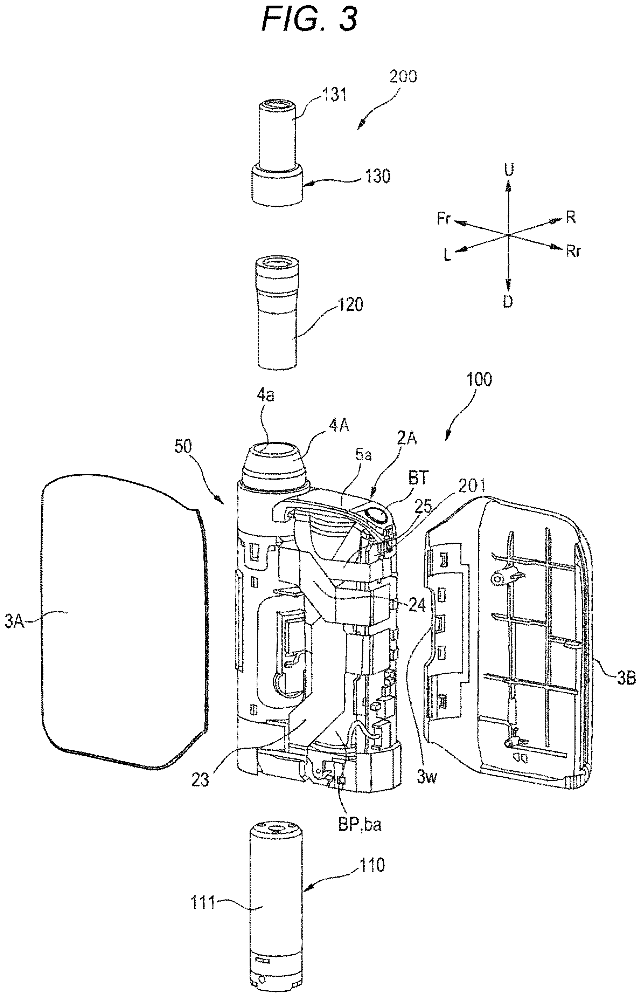

Referring also to FIG. 3, the aerosol generating device 200 includes a power supply unit 100, a first cartridge 110, and a second cartridge 120. The first cartridge 110 and the second cartridge 120 are attachable to and detachable from the power supply unit 100. In other words, the first cartridge 110 and the second cartridge 120 are replaceable.

### (Power Supply Unit)

The power supply unit 100 includes an internal unit 2A and a case 3a, and at least a part of the internal unit 2A is accommodated in the case 3a.

The case 3a includes a first case 3A and a second case 3B that are detachable in the left-right direction (thickness direction), the first case 3A and the second case 3B are assembled in the left-right direction (thickness direction), thereby forming a front surface, a rear surface, a left surface, and a right surface of the power supply unit 100. Specifically, the first case 3A is supported on a left surface of a chassis 50 to be described later in the internal unit 2A, the second case 3B is supported on a right surface of the chassis 50, and the internal unit 2A is accommodated in the case 3. A capsule holder 4A is provided on a front side on the upper surface of the power supply unit 100. The capsule holder 4Ais provided with an opening portion 4a that is opened upward. The capsule holder 4A is configured such that the second cartridge 120 may be inserted through the opening portion 4a. On the second cartridge 120, a mouth piece 130 is detachably provided.

The upper surface of the power supply unit 100 is formed by an organic light-emitting diode (OLED) cover 5a disposed behind the opening portion 4a, and the lower surface of the power supply unit 100 is formed by a pivotable lower lid 7a and a lower cover 8a provided with a charging terminal 1.

An inclined surface inclined downward toward the rear is provided between the upper surface and the rear surface of the power supply unit 100. The inclined surface is provided with an operation unit operable by a user. The operation unit of the present embodiment is a button-type switch BT, but may be implemented by a touch panel or the like. The operation unit is used to start/shut off/operate a micro controller unit (MCU) 6 and various sensors, which will be described later, based on a use intention of the user.

The charging terminal 1 accessible from the lower cover 8a is configured to be electrically connected to an external power supply (not shown) capable of supplying electric power to the power supply unit 100 to charge a power supply ba provided in a battery pack BP. The charging terminal 1 is, for example, a receptacle into which a mating plug can be inserted. As the charging terminal 1, a receptacle into which various USB terminals or the like can be inserted may be used. As an example, in the present embodiment, the charging terminal 1 is a USB Type-C receptacle.

The charging terminal 1 may include, for example, a power receiving coil, and may be configured to receive electric power transmitted from the external power supply in a noncontact manner. In this case, a method for wireless power transfer (WPT) may be of an electromagnetic induction type, a magnetic resonance type, or a combination of the electromagnetic induction type and the magnetic resonance type. As another example, the charging terminal 1 may be connectable to various USB terminals or the like, and may include the above-described power receiving coil.

As shown in FIGs. 3 to 6, the internal unit 2Aincludes the battery pack BP, the chassis 50, a heating unit 60, a circuit unit 70, a notification unit, and various sensors.

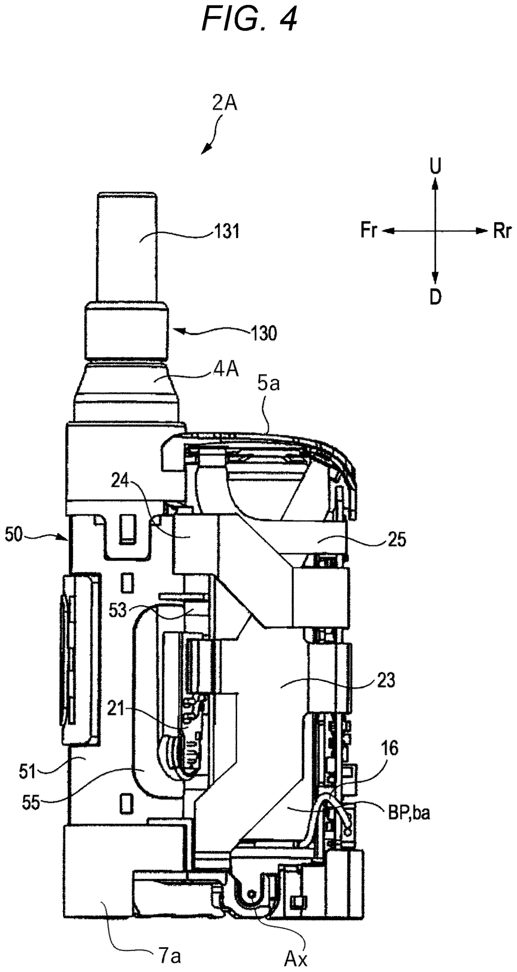

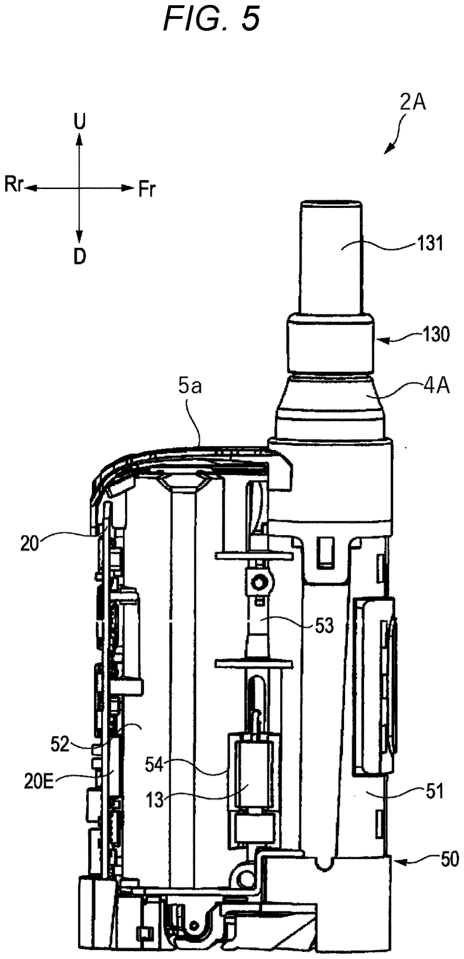

As shown in FIGs. 4 and 5, the chassis 50 includes a cylindrical cartridge holding portion 51 located on a front side, a half-cylindrical battery holding portion 52 located on a rear side and having a left side cut out, a plate-shaped coupling portion 53 coupling the cartridge holding portion 51 and the battery holding portion 52, a motor holding portion 54 provided below and on a right side of the coupling portion 53 in a manner of straddling the cartridge holding portion 51 and the battery holding portion 52, and a sensor holding portion 55 provided on a left rear side of the cartridge holding portion 51.

The first cartridge 110 is inserted into the cartridge holding portion 51 from below in a state where the lower lid 7a is opened. When the lower lid 7a is closed in a state where the first cartridge 110 is inserted, the first cartridge 110 is accommodated in the cartridge holding portion 51. The capsule holder 4A is attached to an upper portion of the cartridge holding portion 51. In the cartridge holding portion 51, a vertically long through hole is provided on a front side, and a remaining amount of an aerosol source of the first cartridge 110 and light of a light emitting diode (LED) 21D to be described later can be visually observed through a remaining amount confirmation window 3w provided at a joint of the first case 3A and the second case 3B. The first cartridge 110 will be described later.

The battery pack BP is disposed in the battery holding portion 52. The battery pack BP includes the power supply ba and a power supply thermistor for detecting a temperature of the power supply ba. The power supply ba is a chargeable secondary battery, an electric double-layer capacitor, or the like, and is preferably a lithium ion secondary battery. An electrolyte of the power supply ba may be constituted by one or a combination of a gel electrolyte, an electrolytic solution, a solid electrolyte, and an ionic liquid.

A vibration motor 13 is disposed in the motor holding portion 54. An inhalation sensor 15 to be described later, which provides an output in response to an inhalation operation (puff operation) of the user, is disposed in the sensor holding portion 55.

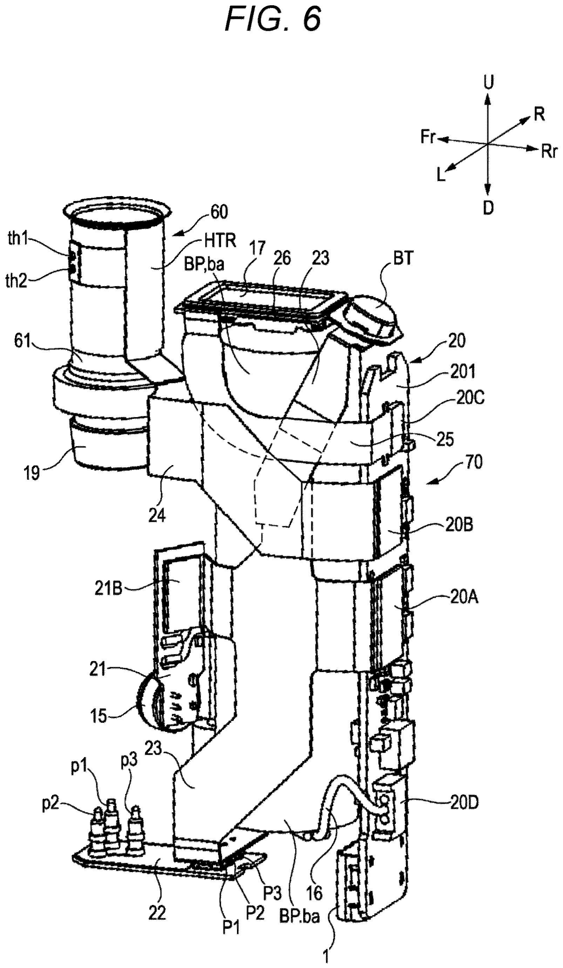

As shown in FIG. 6, the heating unit 60 includes a cylindrical heat transfer tube 61 and a sheet heater HTR wound around an outer periphery of the heat transfer tube 61. The capsule holder 4Ais separately provided around the sheet heater HTR. An air layer between the capsule holder 4A and the sheet heater HTR functions as a heat insulator. A lower portion of the second cartridge 120 inserted from the opening portion 4a of the capsule holder 4A is accommodated in the heat transfer tube 61, and a lower portion of the second cartridge 120 is heated by the sheet heater HTR. Accordingly, as compared with a case where the heating unit 60 is not provided, a flavor source stored in the second cartridge 120 easily releases a flavor, so that the aerosol is easily flavored.

The heating unit 60 may be an element capable of heating the second cartridge 120. Examples of the element include a resistance heating element, a ceramic heater, and an induction-heating-type heater. As the resistance heating element, for example, a heating element having a positive temperature coefficient (PTC) characteristic in which an electrical resistance value increases as the temperature increases is preferably used. Alternatively, a heating element having a negative temperature coefficient (NTC) characteristic in which the electrical resistance value decreases as the temperature increases may be used. The heating unit 60 has a function of defining a flow path of air to be supplied to the second cartridge 120 and a function of heating the second cartridge 120.

The notification unit issues notifications about various kinds of information such as a charging state of the power supply ba, a remaining amount of the first cartridge 110, and a remaining amount of the second cartridge 130. The notification unit of the present embodiment includes the LED 21D and the vibration motor 13. The notification unit may be implemented by a light emitting element such as the LED 21D, a vibration element such as the vibration motor 13, or a sound output element. The notification unit may be a combination of two or more elements among the light emitting element, the vibration element, and the sound output element.

The various sensors include the inhalation sensor 15 that detects the puff operation (inhalation operation) of the user, a heater temperature sensor that detects a temperature of the sheet heater HTR, and the like.

The inhalation sensor 15 includes, for example, a capacitor microphone, a pressure sensor, and a flow rate sensor. A plurality of inhalation sensors 15 may be disposed apart from each other, and the puff operation may be detected based on a difference between output values of the inhalation sensors 15. The heater temperature sensor includes a first thermistor th1 and a second thermistor th2. The first thermistor th1 and the second thermistor th2 are preferably in contact with or close to the sheet heater HTR. When the sheet heater HTR has the PTC characteristic or the NTC characteristic, the sheet heater HTR may be used for the heater temperature sensor. The heater temperature sensor includes two thermistors, but may include one thermistor.

The circuit unit 70 includes four circuit substrates, three flexible printed circuits (FPCs) or flexible printed circuit substrates, a plurality of integrated circuits (ICs), and a plurality of elements. The four circuit substrates include a main substrate 20, the puff sensor substrate 21, a pogo pin substrate 22, and an OLED substrate 26. The three FPCs include a main FPC 23, a heater FPC 24, and an OLED FPC 25. The four circuit substrates are rigid and have sufficiently higher rigidity than the three FPCs.

The main substrate 20 is disposed between the battery pack BP and a rear surface of the case 3a (the rear surface of the power supply unit 100) such that an element mounting surface faces the front-rear direction. The main substrate 20 is configured by laminating a plurality of layers (six layers in the present embodiment) of substrates, and electronic components (elements) such as the MCU 6 and a charging IC 3 are mounted thereon.

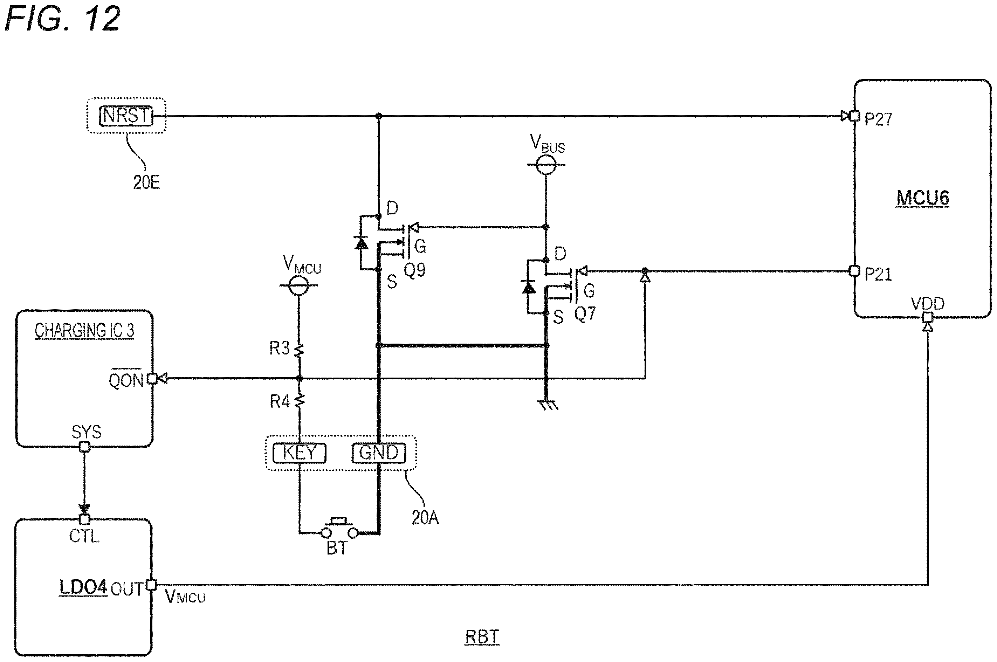

As to be described later in detail with reference to FIG. 12 and the like, the MCU 6 is a control device that is connected to various sensor devices such as the inhalation sensor 15, the operation unit, the notification unit, and a memory or the like that stores the number of times of puff operations, a load, an energization time to the sheet heater HTR, and the like, and performs various controls of the aerosol generating device 200. Specifically, the MCU 6 is implemented by a processor as a main component, and further includes a storage medium such as a random access memory (RAM) necessary for an operation of the processor and a read only memory (ROM) storing various kinds of information. For example, the processor in the present description is an electrical circuit in which circuit elements such as semiconductor devices are combined. A part of the elements (for example, the inhalation sensor 15 and the memory) connected to the MCU 6 may be provided inside the MCU 6 as a function of the MCU 6 itself.

The charging IC 3 is an IC that performs charging control of the power supply ba by the electric power received via the charging terminal 1, and supplies the electric power of the power supply ba to the electronic components and the like on the main substrate 20.

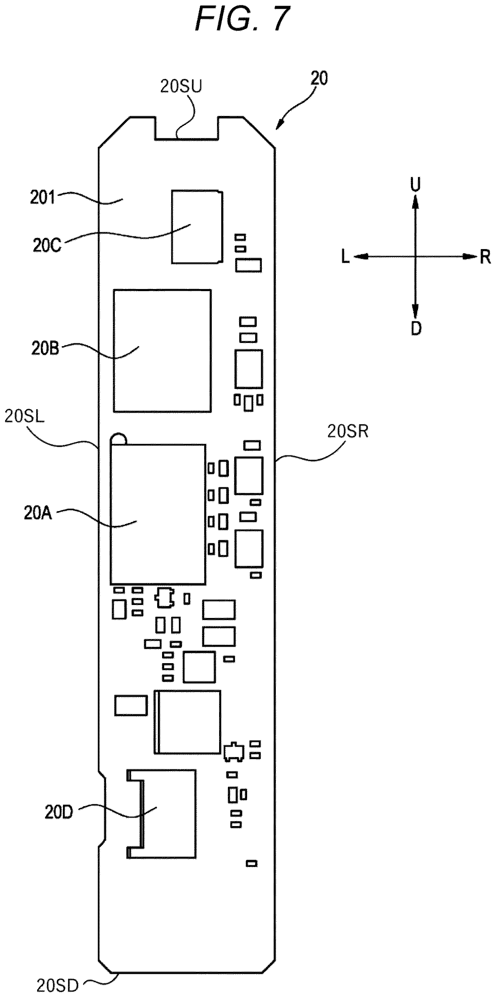

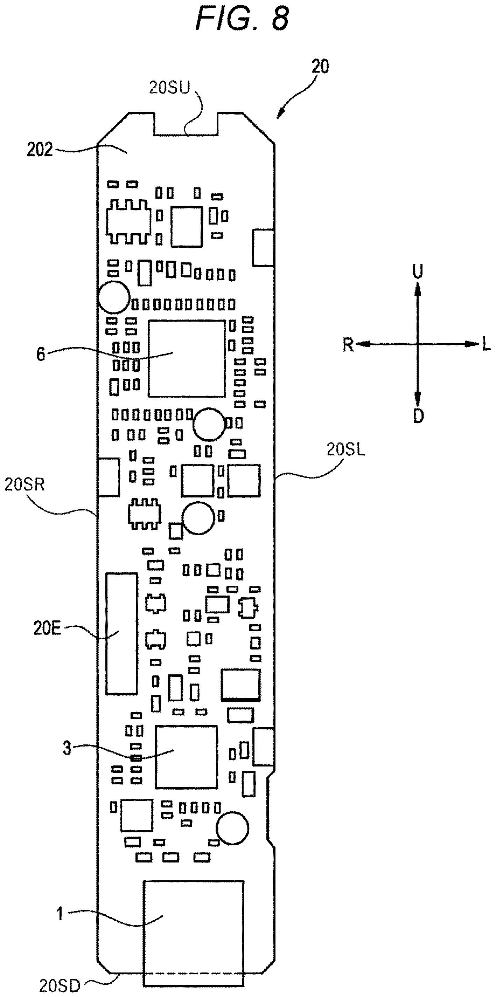

The main substrate 20 will be described more specifically with reference to FIGs. 7 and 8. Hereinafter, a surface of the main substrate 20 facing rearward is referred to as a front surface 201 for convenience, and a surface of the main substrate 20 facing forward is referred to as a back surface 202 for convenience. FIG. 7 is a diagram showing the front surface 201 of the main substrate 20, and FIG. 8 is a diagram showing the back surface 202 of the main substrate 20. The main substrate 20 has a plate shape extending vertically, and FIGs. 7 and 8 show an upper side surface 20SU which is a side surface on an upper side and a lower side surface 20SD which is a side surface on a lower side, as side surfaces orthogonal to a longitudinal direction of the main substrate 20. A left side surface 20SL which is a side surface on a left side and a right side surface 20SR which is a side surface on a right side are shown as side surfaces orthogonal to a short direction of the main substrate 20.

As shown in FIG. 8, the MCU 6 and the charging IC 3 are mounted on the back surface 202 of the main substrate 20 together with the charging terminal 1. A debug connector 20E is further mounted on the back surface 202. The debug connector 20E is an interface for rewriting a program of the MCU 6 from an external device such as a personal computer, and for example, a connector conforming to a Serial Wire Debug (SWD) standard is used. Meanwhile, as shown in FIG. 7, an OLED connector 20C, a heater connector 20B, a main connector 20A, and a battery connector 20D which is connected to the battery pack BP via a lead wire 16 (see FIG. 6) are mounted on the front surface 201 of the main substrate 20.

As shown in FIGs. 4 and 6, the puff sensor substrate 21 is disposed on the sensor holding portion 55 of the chassis 50 such that an element mounting surface faces a right front side and a left rear side. The inhalation sensor 15 is mounted on the puff sensor substrate 21.

As shown in FIG. 6, the OLED substrate 26 is disposed between the battery pack BP and the OLED cover 5a such that an element mounting surface faces the upper-lower direction. An OLED panel 17 is mounted on the OLED substrate 26.

As shown in FIG. 6, the pogo pin substrate 22 is disposed on the lower lid 7a such that an element mounting surface faces the upper-lower direction in a state where the lower lid 7a is closed. The pogo pin substrate 22 is provided with input-side contact points P1 to P3 to which electric power is supplied from the main substrate 20 via the main FPC 23, pogo pins p1 to p3 which are connectors electrically connected to a load provided in the first cartridge 110, and wirings connecting the pogo pins p1 to p3 and the input-side contact points P1 to P3. The input-side contact points P1 to P3 are electrically connected to the main FPC 23 only in a state where the lower lid 7a is closed. The three pogo pins p1 to p3 are provided at equal intervals in a peripheral direction, and at least two pogo pins are electrically connected to a positive terminal and a negative terminal of the first cartridge 110 accommodated in the cartridge holding portion 51.

A left side of the battery pack BP held by the battery holding portion 52 is exposed from the battery holding portion 52 due to the half-cylindrical battery holding portion 52. As shown in FIGs. 3, 4, and 6, the main FPC 23, the heater FPC 24, and the OLED FPC 25 are disposed to overlap one another in a space between the left side of the battery pack BP and the first case 3A, which is formed by cutting out the battery holding portion 52.

Among the three FPCs, the main FPC 23 is routed closest to battery pack BP, the OLED FPC 25 is routed to partially overlap the main FPC 23, and further the heater FPC 24 is routed to overlap the OLED FPC 25. That is, the heater FPC 24 to which the largest electric power is supplied among the three FPCs is routed to be farthest from the battery pack BP. The main FPC 23 has a developed shape of a substantially cross shape, and is folded rearward at a position overlapping the heater FPC 24. That is, the main FPC 23 has a folded wiring. Although the folded portion of the main FPC 23 is likely to float in the left-right direction, the heater FPC 24 and the OLED FPC 25 overlap this portion, thereby preventing such floating. The switch BT is directly mounted on the main FPC 23 without using a rigid substrate or the like.

The OLED FPC 25 has one end connected to the OLED connector 20C of the main substrate 20 and the other end connected to the OLED substrate 26.

The main FPC 23 connects the main connector 20A of the main substrate 20, the switch BT of the operation unit, a connector 21B of the puff sensor substrate 21, and the input-side contact points P1 to P3 of the pogo pin substrate 22.

The heater FPC 24 has one end connected to the heater connector 20B of the main substrate 20, and the other end integrally formed with the sheet heater HTR.

### (First Cartridge)

The first cartridge 110 includes, inside a cylindrical cartridge case 111, a reservoir that stores an aerosol source, an electrical load that atomizes the aerosol source, a wick that draws the aerosol source from the reservoir to the load, and an aerosol flow path through which aerosol generated by atomization of the aerosol source flows toward the second cartridge 120. The aerosol source contains a liquid such as glycerin, propylene glycol, or water.

The load is a heating element that heats, without combustion, the aerosol source by electric power supplied from the power supply ba via the pogo pins p1 to p3 of the pogo pin substrate 22, and is implemented by, for example, a heating wire (coil) wound at a predetermined pitch. The load atomizes the aerosol source by heating the aerosol source. As the load, a heating resistor, a ceramic heater, an induction-heating-type heater, and the like may be used. Hereinafter, the load provided in the first cartridge 110 is also referred to as a liquid heater.

The aerosol flow path is connected to the second cartridge 120 via a flow path forming body 19 (see FIG. 6) accommodated in the cartridge holding portion 51 of the chassis 50.

### (Second Cartridge)

The second cartridge 120 stores a flavor source. When the second cartridge 120 is heated by the sheet heater HTR, the flavor source is heated. The second cartridge 120 flavors the aerosol when the aerosol generated by atomizing the aerosol source by the liquid heater passes through the flavor source. As a raw material piece constituting the flavor source, it is possible to use a molded product obtained by molding a shredded tobacco or a tobacco raw material into granules. The flavor source may be formed of plants other than tobacco (for example, mint, Chinese medicine, and herb). The flavor source may contain a fragrance such as menthol.

The aerosol generating device 200 may generate flavored aerosol using the aerosol source and the flavor source. That is, the aerosol source and the flavor source constitute an aerosol generating source that generates the flavored aerosol.

The aerosol generating source in the aerosol generating device 200 is a portion to be replaced for use by the user. In this portion, for example, one first cartridge 110 and one or a plurality of (for example, five) second cartridges 120 are provided as a set to the user. The battery pack BP may be repeatedly charged and discharged as long as the power supply ba is not significantly deteriorated. Accordingly, in the aerosol generating device 200, a replacement frequency of the power supply unit 100 or the battery pack BP is lowest, a replacement frequency of the first cartridge 110 is second lowest, and a replacement frequency of the second cartridge 120 is highest. The first cartridge 110 and the second cartridge 120 may be integrated into one cartridge. Instead of the flavor source, a chemical agent or the like may be added to the aerosol source.

In the aerosol generating device 200 configured as described above, air flowing in from an air intake port (not shown) provided in the case 3a or the internal unit 2A passes near the load of the first cartridge 110. The load atomizes the aerosol source drawn from the reservoir by the wick. The aerosol generated by atomization flows through the aerosol flow path together with the air flowing in from the intake port, and is supplied to the second cartridge 120 via the flow path forming body 19. The aerosol supplied to the second cartridge 120 is flavored when passing through the flavor source, and is supplied to an inhalation port 131 of the mouth piece 130.

Next, a configuration of the lower lid 7a will be additionally described.

The lower lid 7a is configured to pivot around a rotation axis Ax extending in the left-right direction shown in FIG. 4. Specifically, the lower lid 7a is brought into an open state (a state in which a hollow portion of the cartridge holding portion 51 is exposed) by moving a front end counterclockwise from a closed state (a state in which the hollow portion of the cartridge holding portion 51 is covered) shown in FIG. 4. As shown in FIG. 6, the pogo pin substrate 22 has a flat plate shape, and the input-side contact points P1 to P3 each of which is implemented by a protrusion protruding upward are provided at a rear end of an upper surface of the pogo pin substrate 22. Further, on a front end of the upper surface of the pogo pin substrate 22, the pogo pins p1 to p3 each of which is implemented by a protrusion protruding upward are provided. The pogo pin substrate 22 is fixed to an inner surface (upper surface) of the lower lid 7a. When the lower lid 7a is in the closed state, the input-side contact points P1 to P3 of the pogo pin substrate 22 are in contact with terminals 81T to 83T of conductive patterns 81 to 83 provided on the main FPC 23 to be described later, and an electrical connection between the main FPC 23 and the pogo pin substrate 22 is established. On the other hand, when the lower lid 7a is in the open state, the input-side contact points P1 to P3 of the pogo pin substrate 22 are separated from the terminals 81T to 83T of the conductive patterns 81 to 83 and are not in contact with the conductive patterns 81 to 83. That is, the electrical connection between the main FPC 23 and the pogo pin substrate 22 is released. The main FPC 23 is accommodated inside the case 3 so as not to be deformed due to opening and closing operation of the lower lid 7a. The main FPC 23 being not deformed means that a position of the main FPC 23 inside the case 3 is not substantially changed.

Thus, the lower lid 7a and the pogo pin substrate 22 fixed thereto are portions to which a force is applied when the first cartridge 110 is inserted into and removed from the cartridge holding portion 51. In the present embodiment, the pogo pin substrate 22 is implemented by a rigid circuit substrate. By using a rigid circuit substrate which is inexpensive and rigid at such a position, durability of the power supply unit 100 may be improved.

In the present embodiment, the electrical connection between the pogo pin substrate 22 and the main FPC 23 is established only when the lower lid 7a is in the closed state. Accordingly, the main FPC 23 is less likely to be damaged as compared with a case where the main FPC 23 is interlocked with pivoting of the lower lid 7a.

In the present embodiment, when the first cartridge 110 is inserted and removed, an electrical contact is not established between the main substrate 20 or the power supply ba and the first cartridge 110. Therefore, an unintended short-circuit current is less likely to occur, and safety of the power supply unit 100 may be improved.

Further, in the present embodiment, each of the input-side contact points P1 to P3 to be brought into contact with the main FPC 23 is implemented by a protrusion with a small contact area. Therefore, an external force applied to the main FPC 23 when the lower lid 7a is opened and closed and stress generated by the external force may be reduced.

In the present embodiment, when the second cartridge 120 is inserted into and removed from the capsule holder 4A, the insertion of the first cartridge 110 is unnecessary. That is, the lower lid 7a needs to be opened and closed in order to insert and remove the first cartridge 110 whose replacement frequency is lower than that of the second cartridge 120. Accordingly, the lower lid 7a can be prevented from being frequently opened and closed, and the durability of the power supply unit 100 may be improved.

### (Circuit Structure)

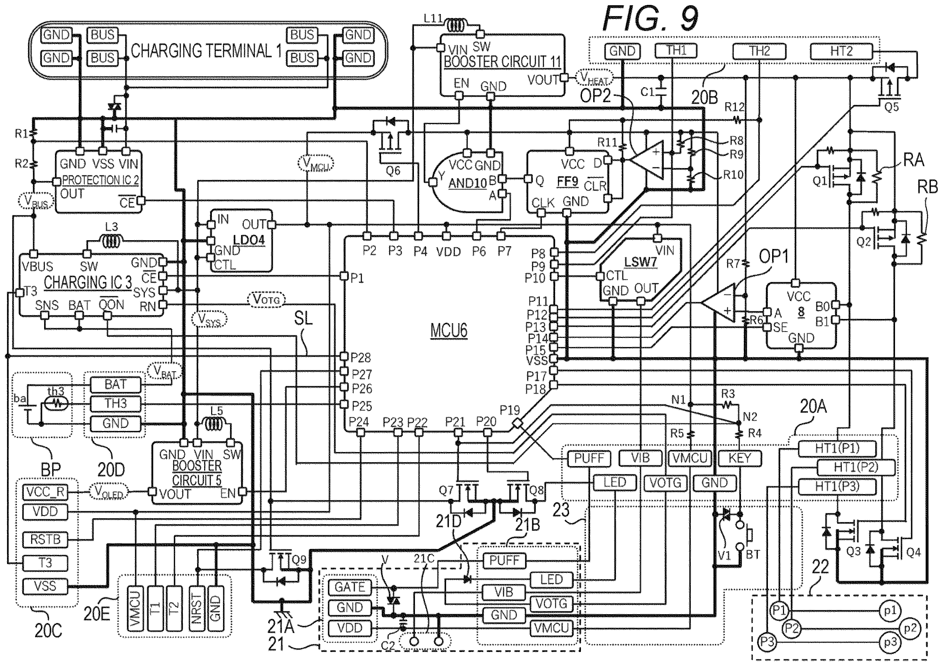

FIG. 9 is a diagram showing a schematic configuration of a circuit provided in the main substrate 20. In addition to the circuit of the main substrate 20, FIG. 9 shows the main FPC 23 connected to the main connector 20A of the main substrate 20, the puff sensor substrate 21 connected to the main FPC 23, the pogo pin substrate 22 connected to the main FPC 23, and the battery pack BP connected to the battery connector 20D.

A wiring indicated by a thick solid line in FIG. 9 is a wiring having the same potential as a reference potential (a ground potential, 0 V as an example below) of the power supply unit 100 (a wiring connected to a ground provided in the power supply unit 100), and the wiring is hereinafter referred to as a ground line.

The main substrate 20 is provided with, as main ICs which are electronic components in each of which a plurality of circuit elements are formed into a chip, a protection IC 2; the charging IC 3; a low dropout (LDO) regulator (hereinafter, referred to as LDO) 4; a booster circuit 5 implemented by a DC/DC converter; the MCU 6; a load switch (hereinafter, referred to as LSW) 7 configured by combining a capacitor, a resistor, a transistor, and the like; a multiplexer 8; a flip-flop (hereinafter, referred to as FF) 9; an AND gate (simply referred to as "AND" in FIG. 9) 10; a booster circuit 11 implemented by a DC/DC converter; an operational amplifier OP1; and an operational amplifier OP2.

The main substrate 20 is further provided with switches Q1 to Q9 each implemented by a metal-oxide-semiconductor field-effect transistor (MOSFET), resistors R1 to R12, RA, and RB each a having fixed electric resistance value, a capacitor C1, a capacitor C2, a varistor V, a varistor V1, a reactor L3 connected to the charging IC 3, a reactor L5 connected to the booster circuit 5, and a reactor L11 connected to the booster circuit 11. Each of the switch Q3, the switch Q4, the switch Q7, the switch Q8, and the switch Q9 is implemented by an N-channel MOSFET. Each of the switch Q1, the switch Q2, the switch Q5, and the switch Q6 is implemented by a P-channel MOSFET. Each of the switches Q1 to Q8 is switched between an ON state and an OFF state by controlling a potential of the gate terminal by the MCU 6.

In FIG. 9, various terminals are denoted by reference numerals in each IC except for the operational amplifier. A terminal VCC and a terminal VDD mounted on the chip each indicate a power supply terminal on a high potential side. A terminal VSS and a terminal GND mounted on the chip each indicate a low-potential-side (reference-potential-side) power supply terminal. In the electronic component formed into a chip, a difference between a potential of the power supply terminal on the high potential side and a potential of the power supply terminal on the low potential side is a power supply voltage (an operating voltage). The electronic component formed into a chip executes various functions by using the power supply voltage.

In FIG. 9, the terminal GND and the terminal VSS of each IC except for the operational amplifier are connected to the ground line. Further, the terminal GND of the charging terminal 1, a negative power supply terminal of the operational amplifier OP1, and a negative power supply terminal of the operational amplifier OP2 are connected to the ground line.

The battery connector 20D (see a vicinity of a left center part in FIG. 9) provided on the main substrate 20 includes a terminal BAT connected to each of a detection terminal SNS of the charging IC 3 and a charging terminal BAT of the charging IC 3; a terminal GND connected to the ground line of the main substrate 20; and a terminal TH3 connected to a terminal P25 of the MCU 6. The terminal BAT of the battery connector 20D is connected, by the lead wire 16, to a positive terminal of the power supply ba provided in the battery pack BP. The terminal TH3 of the battery connector 20D is connected, by the lead wire 16, to a positive terminal of a power supply thermistor th3 provided in the battery pack BP. The terminal GND of the battery connector 20D is connected, by lead wire 16, to a negative terminal of the power supply ba and a negative terminal of the power supply thermistor th3.

The OLED connector 20C (see a vicinity of a lower left part in FIG. 9) provided on the main substrate 20 includes a terminal VCC_R connected to an output terminal VOUT of the booster circuit 5; a terminal VDD connected to an output terminal OUT of the LDO 4; a terminal RSTB connected to a terminal P24 of the MCU 6; a communication terminal T3 connected to a communication terminal P28 of the MCU 6 by a signal line SL; and a terminal VSS connected to the ground line of the main substrate 20.

The terminal VCC_R of the OLED connector 20C is connected to a drive voltage supply terminal of the OLED panel 17 by the OLED FPC 25. The terminal VDD of the OLED connector 20C is connected, by the OLED FPC 25, to a power supply terminal of a control IC for controlling the OLED panel 17. A voltage to be supplied to the drive voltage supply terminal of the OLED panel 17 is, for example, about 15 V, which is higher than a voltage to be supplied to the power supply terminal of the control IC of the OLED panel 17. The terminal VSS of the OLED connector 20C is connected, by the OLED FPC 25, to respective ground terminals of the OLED panel 17 and the control IC of the OLED panel 17. The terminal RSTB of the OLED connector 20C is connected, by the OLED FPC 25, to a terminal for restarting the control IC of the OLED panel 17.

The signal line SL connected to the communication terminal T3 of the OLED connector 20C is also connected to a communication terminal T3 of the charging IC 3. Through the signal line SL, the MCU 6 may communicate with the charging IC 3 and the control IC of the OLED panel 17. The signal line SL is used for serial communication, and a plurality of signal lines such as a data line for data transmission and a clock line for synchronization are actually required. It should be noted that, in FIG. 9, the signal line SL is shown as one signal line for simplification. The communication between the MCU 6 and the charging IC 3 and the control IC of the OLED panel 17 may be performed by parallel communication instead of serial communication.

The debug connector 20E (see a vicinity of a lower left part in FIG. 9) provided on the main substrate 20 includes a terminal VMCU connected to the output terminal OUT of the LDO 4; a terminal T1 (one terminal is shown in the drawing, but there are two terminals actually) connected to a communication terminal P23 of the MCU 6; a terminal T2 (one terminal is shown in the drawing, but there are two terminals actually) connected to a communication terminal P22 of the MCU 6; a terminal NRST connected to a terminal P27 of the MCU 6; and a terminal GND connected to the ground line of the main substrate 20. The terminal NRST is also connected to a drain terminal of the switch Q9 whose gate terminal is connected to a drain terminal of the switch Q7 and whose source terminal is connected to the ground line. The debug connector 20E is not used in a normal use state of the aerosol generating device 200, and is used by being connected to a computer prepared by a manufacturer or a seller only when maintenance such as rewriting of information (including a program) stored in the MCU 6 is necessary.

The main connector 20A (see a vicinity of a right center part in FIG. 9) provided on the main substrate 20 includes a terminal PUFF connected to a terminal P19 of the MCU 6; a terminal LED connected to a drain terminal of a switch Q8 whose gate terminal is connected to a terminal P20 of the MCU 6 and whose source terminal is connected to the ground line; a terminal VIB connected to an output terminal OUT of the LSW 7; a terminal VOTG connected to a booster output terminal RN of the charging IC 3; a terminal VMCU connected to the output terminal OUT of the LDO 4 via a resistor R5; a terminal GND connected to the ground line; a terminal KEY connected to the output terminal OUT of the LDO 4 via a voltage dividing circuit including a resistor R4 and a resistor R3 connected in series to the resistor R4; a terminal HT1 (P1) connected to a drain terminal of the switch Q1 whose gate terminal is connected to a terminal P12 of the MCU 6 and whose source terminal is connected to an output terminal VOUT of the booster circuit 11; a terminal HT1 (P2) connected to a drain terminal of the switch Q2 whose gate terminal is connected to a terminal P13 of the MCU 6 and whose source terminal is connected to the output terminal VOUT of the booster circuit 11 and a drain terminal of the switch Q4 whose gate terminal is connected to a terminal P17 of the MCU 6 and whose source terminal is connected to the ground line; and a terminal HT1 (P3) connected to a drain terminal of the switch Q3 whose gate terminal is connected to a terminal P18 of the MCU 6 and whose source terminal is connected to the ground line.

The terminal HT1 (P1) of the main connector 20Ais connected, by the main FPC 23, to the input-side contact point P1 connected to the pogo pin p1. The terminal HT1 (P2) of the main connector 20A is connected, by the main FPC 23, to the input-side contact point P2 connected to the pogo pin p2. The terminal HT1 (P3) of the main connector 20Ais connected, by the main FPC 23, to the input-side contact point P3 connected to the pogo pin p3. The terminal KEY of the main connector 20A is connected, by a wiring of the main FPC 23, to one end of the switch BT mounted on the main FPC 23. The other end of the switch BT is connected to a ground line of the main FPC 23.

The heater connector 20B (see a vicinity of an upper right part in FIG. 9) provided on the main substrate 20 includes a first thermistor terminal TH1 connected, via a wiring of the heater FPC 24, to a positive terminal of a first thermistor th1 mounted on the heater FPC 24; a second thermistor terminal TH2 connected, via a wiring of the heater FPC 24, to a positive terminal of a second thermistor th2 mounted on the heater FPC 24; a sheet heater terminal HT2 connected, via a wiring of the heater FPC 24, to a positive terminal of the sheet heater HTR formed by a conductive pattern of the heater FPC 24; and a terminal GND connected to the ground line of the main substrate 20. The heater FPC 24 is provided with wirings connected to a negative terminal of the first thermistor th1, a negative terminal of the second thermistor th2, and a negative terminal of the sheet heater HTR, and the wirings are connected to the terminal GND of the heater connector 20B. The sheet heater terminal HT2 is connected to a drain terminal of the switch Q5 whose gate terminal is connected to a terminal P1 1 of the MCU 6 and whose source terminal is connected to the output terminal VOUT of the booster circuit 11.

The puff sensor connector 21A connected to the terminal group 15A of the inhalation sensor 15, the connector 21B connected to the main FPC 23, the vibration motor connector 21C connected to the vibration motor 13, the LED 21D, the varistor V, and the capacitor C2 are mounted on the puff sensor substrate 21 (see a vicinity of a lower center part in FIG. 9).

The connector 21B of the puff sensor substrate 21 includes terminals (a terminal PUFF, a terminal LED, a terminal VIB, a terminal VOTG, a terminal VMCU, and a terminal GND) connected by wirings formed on the main FPC 23 to the terminal PUFF, the terminal LED, the terminal VIB, the terminal VOTG, the terminal VMCU, and the terminal GND of the main connector 20A respectively. As described above, the main FPC 23 is provided with the switch BT connected between the terminal KEY of the main connector 20A and the ground line. When the switch BT is pressed down, the terminal KEY is connected to the ground line of the main FPC 23, and a potential of the terminal KEY gets to a ground potential. On the other hand, in a state where the switch BT is not pressed down, the terminal KEY is not connected to the ground line of the main FPC 23, and the potential of the terminal KEY is undefined.

The puff sensor connector 21A of the puff sensor substrate 21 includes a terminal GATE connected to the output terminal of the inhalation sensor 15, a terminal GND connected to the ground terminal of the inhalation sensor 15, and a terminal VDD connected to the power supply terminal of the inhalation sensor 15. The terminal GATE of the puff sensor connector 21A is connected to the terminal PUFF of the connector 21B. The terminal VDD of the puff sensor connector 21A is connected to the terminal VMCU of the connector 21B. The terminal GND of the puff sensor connector 21A is connected to the terminal GND of the connector 21B. One end of the varistor V is connected to a connection line between the terminal GATE of the puff sensor connector 21A and the terminal PUFF of the connector 21B, and the other end of the varistor V is connected to the ground line. Even when a large voltage is input to the terminal GATE from an inhalation sensor 15 side, the varistor V can prevent the voltage from being input to other components of the puff sensor substrate 21 or the MCU 6. One end of the capacitor C2 is connected to a connection line between the terminal VDD of the puff sensor connector 21A and the terminal VMCU of the connector 21B, and the other end of the capacitor C2 is connected to the ground line. Even when an unstable voltage is input to the terminal VDD of the puff sensor connector 21A from a main substrate 20 side via the capacitor C2, a voltage smoothed by the capacitor C2 may be input to the inhalation sensor 15.

The vibration motor connector 21C of the puff sensor substrate 21 includes a positive terminal connected to the terminal VIB of the connector 21B and a negative terminal connected to the ground line. The vibration motor 13 is connected to the positive terminal and the negative terminal.

The LED 21D of the puff sensor substrate 21 has an anode connected to the terminal VOTG of the connector 21B and a cathode connected to the terminal LED of the connector 21B.

The charging terminal 1 on an upper left part in FIG. 9 includes four terminals GND and four power supply input terminals BUS. Each power supply input terminal BUS of the charging terminal 1 is connected in parallel to an input terminal VIN of the protection IC 2. In a state where a USB plug is connected to the charging terminal 1 and a USB cable including the USB plug is connected to an external power supply, that is, in a state where the USB connection is established, a USB voltage V_{USB} is input to the input terminal VIN of the protection IC 2 via the power supply input terminal BUS of the charging terminal 1.

The protection IC 2 adjusts the USB voltage V_{USB} input to the input terminal VIN, and outputs a bus voltage V_{BUS} of a predetermined value (hereinafter, for example, 5.0 V) from an output terminal OUT. The charging IC 3, a voltage dividing circuit implemented by a series circuit including a resistor R1 and a resistor R2, and a switch Q7 are connected in parallel to the output terminal OUT of the protection IC 2. Specifically, the output terminal OUT of the protection IC 2 is connected to one end of the resistor R2 constituting the voltage dividing circuit, an input terminal VBUS of the charging IC 3, and the drain terminal of the switch Q7 whose gate terminal is connected to a terminal P21 of the MCU 6 and whose source terminal is connected to the ground line. One end of the resistor R1 is connected to the other end of the resistor R2, and the other end of the resistor R1 is connected to the ground line. A node connecting the resistor R1 and the resistor R2 is connected to a terminal P2 of the MCU 6. The protection IC 2 outputs the bus voltage V_{BUS} from the output terminal OUT in a state where a low level signal is input from the MCU 6 to a negative logic enable terminal CE(⁻),and stops outputting the bus voltage V_{BUS} from the output terminal OUT in a state where a high level signal is input from the MCU 6 to the enable terminal CE(⁻).

The charging IC 3 has a charging function of charging the power supply ba based on the bus voltage V_{BUS} input to the input terminal VBUS. The charging IC 3 acquires a charging current and a charging voltage of the power supply ba by a detection terminal SNS, and performs a charging control on the power supply ba (a control on power supply from the charging terminal BAT to the power supply ba) based on the charging current and the charging voltage. Further, the charging IC 3 acquires temperature information of the power supply ba, that is acquired by the MCU 6 from the electric power supply thermistor th3 via the terminal P25, from the MCU 6 by serial communication using the signal line SL, and uses the temperature information for the charging control.

The charging IC 3 has a first function of generating a system power supply voltage V_{SYS} from a voltage (hereinafter, referred to as a power supply voltage V_{BAT}) of the power supply ba input to the charging terminal BAT and outputting the system power supply voltage V_{SYS} from an output terminal SYS, a second function of generating the system power supply voltage V_{SYS} from the bus voltage V_{BUS} input to the input terminal VBUS and outputting the system power supply voltage V_{SYS} from the output terminal SYS, and a third function of outputting, from a booster output terminal RN, an OTG voltage V_{OTG} (for example, a voltage of 5 V) obtained by boosting the power supply voltage V_{BAT} input to the charging terminal BAT. The second function is enabled only in a state where the USB connection is established. As described above, the system power supply voltage V_{SYS} and the OTG voltage V_{OTG} are in a normal state where the power supply ba can supply electric power to the charging IC 3, and if the charging IC 3 is operating normally, output from the charging IC 3 is constantly possible.

One end of the reactor L3 is connected to a switching terminal SW of the charging IC 3. The other end of the reactor L3 is connected to the output terminal SYS of the charging IC 3. The charging IC 3 includes a negative logic enable terminal CE(⁻), and the enable terminal CE(⁻) is connected to a terminal P1 of the MCU 6. When a high level signal is input to the terminal P2 by establishing the USB connection, the MCU 6 controls a potential of the terminal P1 to get to a low level, and thereby charging control of the charging IC 3 on the power supply ba is permitted and the second function is enabled.

The charging IC 3 further includes a negative logic terminal QON(⁻). The terminal QON(⁻) is connected to a node N2 connecting the resistor R3 and the resistor R4, and the node N2 is connected to the terminal P21 of the MCU 6. When a low level signal is input to the terminal QON(⁻), the charging IC 3 stops the voltage output from the output terminal SYS.

The LDO 4, the booster circuit 5, and the booster circuit 11 are connected in parallel to the output terminal SYS of the charging IC 3. Specifically, the output terminal SYS of the charging IC 3 is connected to a control terminal CTL and an input terminal IN of the LDO 4, an input terminal VIN of the booster circuit 5, and an input terminal VIN of the booster circuit 11. The OTG voltage V_{OTG} output from the booster output terminal RN of the charging IC 3 is supplied to the anode of the LED 21D via the terminal VOTG of the main connector 20A and the terminal VOTG of the connector 21B. A cathode of the LED 21D is connected to ground via the terminal LED of the connector 21B, the terminal LED of the main connector 20A, and the switch Q8. Therefore, by the MCU 6 performing an ON/OFF control of the switch Q8, a lighting control on the LED 21D using the OTG voltage V_{OTG} may be performed.

The booster circuit 5 includes a switching terminal SW, a positive logic enable terminal EN connected to a terminal P26 of the MCU 6, an output terminal VOUT, and a terminal GND. One end of the reactor L5 is connected to the switching terminal SW of the booster circuit 5. The other end of the reactor L5 is connected to the input terminal VIN of the booster circuit 5. The booster circuit 5 performs an ON/OFF control of a built-in transistor connected to the switching terminal SW, thereby boosting a voltage input to the switching terminal SW via the reactor L5 and outputting the boosted voltage from the output terminal VOUT. An OLED voltage V_{OLED} output from the output terminal VOUT of the booster circuit 5 is a sufficiently high voltage suitable for driving the OLED panel 17, and is a voltage of 15 V as an example. The input terminal VIN of the booster circuit 5 constitutes a high-potential-side power supply terminal of the booster circuit 5. The booster circuit 5 outputs the OLED voltage V_{OLED} when a signal input from the terminal P26 of the MCU 6 to the enable terminal EN gets to a high level, and stops outputting the OLED voltage V_{OLED} when the signal input from the terminal P26 of the MCU 6 to the enable terminal EN gets to a low level. In this manner, the OLED panel 17 is driven and controlled by the MCU 6.

The booster circuit 11 includes an input terminal VIN, a switching terminal SW, an output terminal VOUT, a positive logic enable terminal EN, and a terminal GND. One end of the reactor L11 is connected to the switching terminal SW of the booster circuit 11. The other end of the reactor L11 is connected to the input terminal VIN of the booster circuit 11. The booster circuit 11 performs an ON/OFF control of a built-in transistor connected to the switching terminal SW, thereby boosting a voltage input to the switching terminal SW via the reactor L11 and outputting the boosted voltage from the output terminal VOUT. A heating voltage V_{HEAT} output from the output terminal VOUT of the booster circuit 11 is, for example, a voltage of 4 V The input terminal VIN of the booster circuit 11 constitutes a high-potential-side power supply terminal of the booster circuit 11. The booster circuit 11 outputs the heating voltage V_{HEAT} when a signal input from an output terminal Y of the AND gate 10 to be described later to the enable terminal EN gets to a high level, and stops outputting the heating voltage V_{HEAT} when the signal input to the enable terminal EN gets to a low level.

The capacitor C1, a voltage dividing circuit implemented by a series circuit including a resistor R7 and a resistor R6, the multiplexer 8, the switch Q1, the switch Q2, and the switch Q5 are connected in parallel to the output terminal VOUT of the booster circuit 11. Specifically, the output terminal VOUT of the booster circuit 11 is connected to one end of the capacitor C1 the other end of which is connected to the ground line; an input terminal of the voltage dividing circuit including the resistor R6 connected to the ground line and the resistor R7 connected in series to the resistor R6 (a terminal opposite to a resistor R6 side of the resistor R7); a terminal VCC of the multiplexer 8; a source terminal of the switch Q1; a source terminal of the switch Q2; and a source terminal of the switch Q5.

A resistor RA having an electric resistance value Ra is connected in parallel to the switch Q1. A resistor RB having an electric resistance value Rb is connected in parallel to the switch Q2.

The multiplexer 8 includes an input terminal B0, an input terminal B1, an output terminal A, and a select terminal SE. The multiplexer 8 switches between a state where the input terminal B0 and the output terminal A are connected and a state where the input terminal B1 and the output terminal A are connected according to a control signal input from a terminal P15 of the MCU 6 to the select terminal SE.

The input terminal B0 of the multiplexer 8 is connected to a line connecting the switch Q1 and the terminal HT1 (P1). The input terminal B1 of the multiplexer 8 is connected to a line connecting the switch Q2 and the terminal HT1 (P2). The output terminal A of the multiplexer 8 is connected to a noninverting input terminal of the operational amplifier OP1. An inverting input terminal of the operational amplifier OP1 is connected to a node connecting the resistor R7 and the resistor R6. An output terminal of the operational amplifier OP1 is connected to a terminal P14 of the MCU 6.

In a state where a signal input to the control terminal CTL is at a high level (in other words, a state where the system power supply voltage V_{SYS} is output from the output terminal SYS of the charging IC 3), the LDO 4 converts a voltage input to the input terminal VIN (that is, the system power supply voltage V_{SYS}) and outputs the obtained voltage as a system power supply voltage V_{MCU} from the output terminal OUT. The system power supply voltage V_{SYS} is a value in a range of 3.5 V to 4.2 V as an example, and the system power supply voltage V_{MCU} is 3.1 V as an example.

The control IC of the OLED panel 17, the MCU 6, the LSW 7, the inhalation sensor 15, a series circuit including the resistor R3, the resistor R4, and the switch BT, and the debug connector 20E are connected in parallel to the output terminal OUT of the LDO 4. Specifically, the output terminal OUT of the LDO 4 is connected to the terminal VDD of the OLED connector 20C, a terminal VDD of the MCU 6, an input terminal VIN of the LSW 7, one end (a node N1 in the drawing) of the resistor R5 the other end of which is connected to a terminal VMCU of the main connector 20A, an input end (the node N1 in the drawing) of the voltage dividing circuit including the resistor R4 and the resistor R3, and the terminal VMCU of the debug connector 20E.

Further, the output terminal OUT of the LDO 4 is connected to a source terminal of the switch Q6 whose gate terminal is connected to a terminal P4 of the MCU 6. A terminal VCC of the AND gate 10, a terminal VCC of the FF9, one end of a resistor R11, one end of a resistor R12, a positive power supply terminal of the operational amplifier OP2, one end of a resistor R8, one end of a resistor R9, and a positive power supply terminal of the operational amplifier OP1 are connected in parallel to a drain terminal of the switch Q6.

The other end of the resistor R12 is connected to the second thermistor terminal TH2, and a series circuit including the resistor R12 and the second thermistor th2 connected to the second thermistor terminal TH2 constitutes a voltage dividing circuit to which the system power supply voltage V_{MCU} is applied. An output of the voltage dividing circuit corresponds to an electric resistance value (in other words, a temperature) of the second thermistor th2, and is input to the terminal P8 of the MCU 6. Thus, the MCU 6 may acquire the temperature of the second thermistor th2. In the present embodiment, as the second thermistor th2, a thermistor having the NTC characteristic in which the resistance value decreases as the temperature increases is used, but a thermistor having the PTC characteristic in which the resistance value increases as the temperature increases may be used.

One end of a resistor R10 is connected to the other end of the resistor R9, and the other end of the resistor R10 is connected to the ground line. A series circuit including the resistor R9 and the resistor R10 constitutes a voltage dividing circuit to which the system power supply voltage V_{MCU} is applied. An output of the voltage dividing circuit is connected to an inverting input terminal of the operational amplifier OP2, and a fixed voltage value is input to the inverting input terminal. The other end of the resistor R8 is connected to a noninverting input terminal of the operational amplifier OP2.

The other end of the resistor R8 is further connected to the first thermistor terminal TH1 and a terminal P9 of the MCU 6. A series circuit including the resistor R8 and the first thermistor th1 connected to the first thermistor terminal TH1 constitutes a voltage dividing circuit to which the system power supply voltage V_{MCU} is applied. An output of the voltage dividing circuit corresponds to an electric resistance value (in other words, a temperature) of the first thermistor th1, and is input to the terminal P9 of the MCU 6. Accordingly, the MCU 6 may acquire the temperature of the first thermistor th1 (in other words, a temperature of the sheet heater HTR). Further, an output of the voltage dividing circuit is also input to the noninverting input terminal of the operational amplifier OP2. In the present embodiment, as the first thermistor th1, a thermistor having the NTC characteristic in which the resistance value decreases as the temperature increases is used. Therefore, an output of the operational amplifier OP2 gets to a low level when the temperature of the first thermistor th1 (the temperature of the sheet heater HTR) increases and the temperature is equal to or higher than a threshold THD1. In other words, as long as the temperature of the first thermistor th1 (the temperature of the sheet heater HTR) is in a normal range, the output of the operational amplifier OP2 is at a high level.

In a case where a thermistor having the PTC characteristic in which the resistance value increases as the temperature increases is used as the first thermistor th1, an output of the voltage dividing circuit including the first thermistor th1 and the resistor R8 may be connected to the inverting input terminal of the operational amplifier OP2, and an output of the voltage dividing circuit including the resistor R9 and the resistor R10 may be connected to the noninverting input terminal of the operational amplifier OP2. In this case, when the temperature of the first thermistor th1 (the temperature of the sheet heater HTR) increases and the temperature is equal to or higher than the threshold THD1, the output of the operational amplifier OP2 also gets to a low level.

An output terminal of the operational amplifier OP2 is connected to an input terminal D of the FF9. The other end of the resistor R11 and a negative logic clear terminal CLR(⁻) provided in the FF9 are connected to a node connecting the input terminal D of the FF9 and the output terminal of the operational amplifier OP2. That is, the input terminal D of the FF9, the clear terminal CLR(⁻) of the FF9, and the output terminal of the operational amplifier OP2 are pulled up to a supply line of the system power supply voltage V_{MCU} by the resistor R11.

The FF9 has a clock terminal CLK, the clock terminal CLK is connected to a terminal P7 of the MCU 6. The FF9 has an output terminal Q, and the output terminal Q is connected to an input terminal B of the AND gate 10. In a state where a clock signal is input from the MCU 6 to the clock terminal CLK and a high level signal is input to the clear terminal CLR(⁻), the FF9 holds data (high or low data) according to a level of a signal input to the input terminal D and outputs the held data from the output terminal Q. In a state where the clock signal is input from the MCU 6 to the clock terminal CLK and the low level signal is input to the clear terminal CLR(⁻), the FF 9 performs reset processing of outputting the low level signal from the output terminal Q regardless of the held data. The reset processing is cancelled by re-inputting a clock signal to the clock terminal CLK in a state where a high level signal is input to the clear terminal CLR(⁻). That is, the supply of the clock signal to the clock terminal CLK is stopped in a state where a high level signal is input to the clear terminal CLR(⁻), and then the supply of the clock signal is resumed, thus cancelling the reset processing.

An input terminal A of the AND gate 10 is connected to a terminal P6 of the MCU 6. The output terminal Y of the AND gate 10 is connected to a positive logic enable terminal EN of the booster circuit 11. The AND gate 10 outputs a high level signal from the output terminal Y only in a state where both the signal input to the input terminal A and the signal input to the input terminal B are at a high level.

When a control signal is input to a control terminal CTL from a terminal P10 of the MCU 6, the LSW 7 outputs, from the output terminal OUT, the system power supply voltage V_{MCU} input to the input terminal VIN. The output terminal OUT of the LSW 7 is connected to the vibration motor 13 via the terminal VIB of the main substrate 20 and the terminal VIB of the puff sensor substrate 21. Therefore, when the MCU 6 inputs the control signal to the LSW 7, the vibration motor 13 may be operated using the system power supply voltage V_{MCU}.

### (Transition from Standby Mode to Heating Mode)

The power supply unit 100 has, as operation modes, a sleep mode in which power saving is achieved, a standby mode in which transition from the sleep mode is possible, and a heating mode in which transition from the standby mode is possible (a mode in which the liquid heater or the sheet heater HTR performs heating and aerosol is generated). When a specific operation (for example, a long-press operation) on the switch BT is detected in the sleep mode, the MCU 6 switches the operation mode to the standby mode. When a specific operation (for example, a short-press operation) on the switch BT is detected in the standby mode, the MCU 6 switches the operation mode to the heating mode.

### (Operation of Heating Mode)

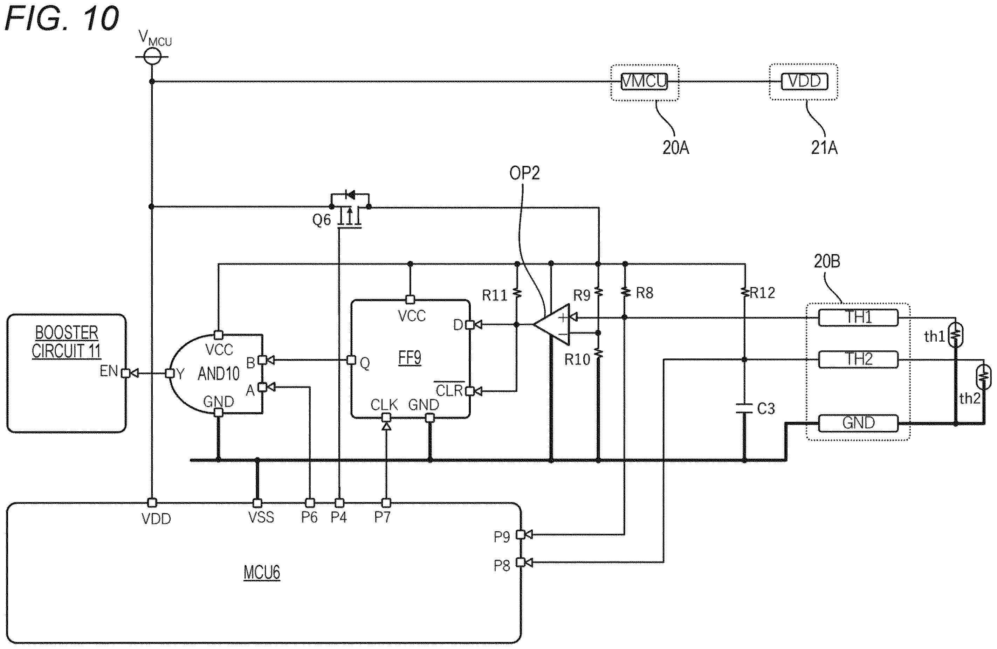

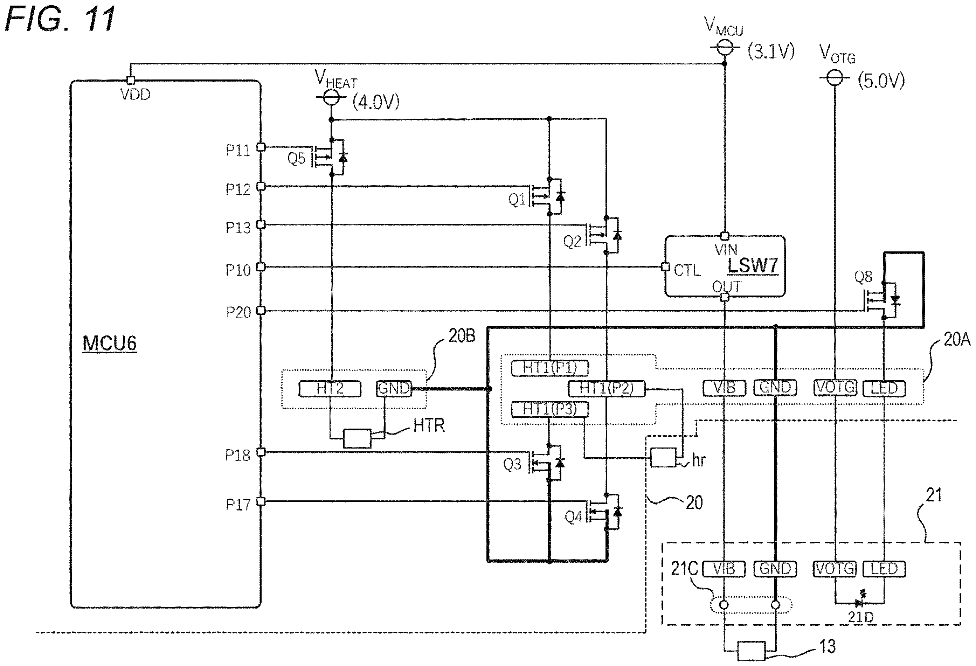

FIG. 10 is a circuit diagram showing electronic components related to an operation in the heating mode and extracted from the circuit shown in FIG. 9. In FIG. 10, a capacitor C3 not shown in FIG. 9 is additionally shown. FIG. 11 is a circuit diagram showing electronic components related to a heating control of the sheet heater HTR and the liquid heater, a driving control of the vibration motor 13, and a driving control of the LED 21D and extracted from the circuit shown in FIG. 9. Hereinafter, the operation in the heating mode will be described with reference to FIGs. 10 and 11.

When transitioning to the heating mode, the MCU 6 controls the switch Q6 shown in FIG. 10 to an ON state. Thus, the system power supply voltage V_{MCU} is supplied to the AND gate 10, the FF9, the resistor R11, the operational amplifier OP2, the resistor R11, the voltage dividing circuit including the resistor R9 and the resistor R10, the voltage dividing circuit including the resistor R8 and the first thermistor th1, the voltage dividing circuit including the resistor R12 and the second thermistor th2, and the operational amplifier OP1. Further, when transitioning to the heating mode, the MCU 6 controls a signal input from the terminal P6 to the input terminal A of the AND gate 10 to get to a high level. The MCU 6 starts inputting the clock signal to the clock terminal CLK of the FF9. In this state, as long as the temperature of the first thermistor th1 (the temperature of the sheet heater HTR) is in a normal range (less than the threshold THD1), the output of the operational amplifier OP2 is at a high level, as a result, the output of the FF9 is at a high level, and as a result, the output of the AND gate 10 is at a high level. Therefore, the booster circuit 11 starts outputting the heating voltage V_{HEAT}, and heating of the sheet heater HTR and the liquid heater is possible.

### (Determination of Connection Destination of Liquid Heater)

When the booster circuit 11 starts outputting the heating voltage V_{HEAT}, as shown in FIG. 11, electric power may be supplied to the sheet heater HTR connected to the sheet heater terminal HT2, and a liquid heater connected to any two of the terminals HT1 (P1) to the terminal HT1 (P3) (in FIG. 11, a liquid heater htr connected to the terminal HT1 (P1) and the terminal HT1 (P2) is shown). In this state, first, the MCU 6 determines, based on the output of the operational amplifier OP1 shown in FIG. 9, to which pair among the pogo pin p1, the pogo pin p2, and the pogo pin p3 the liquid heater is connected. The determination processing includes the following first step, second step, and third step.

### (First Step)

The MCU 6 performs a control to connect the input terminal B0 and the output terminal A of the multiplexer 8 in a state where only the switch Q4 among the switches Q1 to Q4 is controlled to an ON state. In this state, when it is assumed that an electric resistance value between the terminal HT1 (P1) and the terminal HT1 (P2) is Rx, a divided voltage value = V_{HEAT} * {Rx/(Ra + Rx)} is input to the noninverting input terminal of the operational amplifier OP1. In the operational amplifier OP1, the voltage input to the noninverting input terminal is compared with the value of the divided voltage value when the liquid heater is connected between the terminal HT1 (P1) and the terminal HT1 (P2), and if the difference is small, the output of the operational amplifier OP1 gets to a low level. Therefore, when the output of the operational amplifier OP1 gets to a low level, the MCU 6 determines that the liquid heater is connected between the terminal HT1 (P1) and the terminal HT1 (P2).

### (Second Step)

When the output of the operational amplifier OP1 gets to a high level in the first step, the MCU 6 performs a control to connect the input terminal B0 and the output terminal A of the multiplexer 8 in a state where only the switch Q3 among the switches Q1 to Q4 is controlled to an ON state. In this state, when the liquid heater is connected between the terminal HT1 (P1) and the terminal HT1 (P3), the output of the operational amplifier OP1 gets to a low level. Therefore, when the output of the operational amplifier OP1 gets to a low level, the MCU 6 determines that the liquid heater is connected between the terminal HT1 (P1) and the terminal HT1 (P3).

### (Third Step)

When the output of the operational amplifier OP1 gets to a high level in the second step, the MCU 6 performs a control to connect the input terminal B 1 and the output terminal A of the multiplexer 8 in a state where only the switch Q3 among the switches Q1 to Q4 is controlled to an ON state. In this state, when the liquid heater is connected between the terminal HT1 (P2) and the terminal HT1 (P3), the output of the operational amplifier OP1 gets to a low level. Therefore, when the output of the operational amplifier OP1 gets to a low level, the MCU 6 determines that the liquid heater is connected between the terminal HT1 (P2) and the terminal HT1 (P3).

When the output of the operational amplifier OP1 does not get to a low level in any of the first step to the third step, the MCU 6 issues an error notification.

### (Start of Heating Control)

When a level of the output of the inhalation sensor 15 is changed to a value corresponding to the inhalation performed by the user in a state where the determination processing is finished, the MCU 6 starts the heating control of the sheet heater HTR and the liquid heater. Specifically, the MCU 6 performs the heating control of the sheet heater HTR by performing an ON/OFF control (for example, a PWM control or a PFM control) of the switch Q5 shown in FIG. 11. At this time, the MCU 6 performs, based on the temperature of the second thermistor th2 (in other words, the temperature of the sheet heater HTR) acquired from the signal input to the terminal P8, the heating control of the sheet heater HTR such that the temperature of the sheet heater HTR converges to a target temperature. As the heating control, for example, a Proportional-Integral-Differential (PID) control is used.

In addition, when the liquid heater is connected between the terminal HT1 (P1) and the terminal HT1 (P2), the MCU 6 performs the heating control of the liquid heater by controlling the switch Q4 to an ON state, controlling the switch Q2 and the switch Q3 to an OFF state, and performing an ON/OFF control (for example, the PWM control or the PFM control) on the switch Q1 among the switches Q1 to Q4 shown in FIG. 11. When the liquid heater is connected between the terminal HT1 (P1) and the terminal HT1 (P3), the MCU 6 performs the heating control of the liquid heater by controlling the switch Q3 to an ON state, controlling the switch Q2 and the switch Q4 to an OFF state, and performing an ON/OFF control on the switch Q1 among the switches Q1 to Q4. When the liquid heater is connected between the terminal HT1 (P2) and the terminal HT1 (P3), the MCU 6 performs the heating control of the liquid heater by controlling the switch Q3 to an ON state, controlling the switch Q1 and the switch Q4 to an OFF state, and performing an ON/OFF control on the switch Q2 among the switches Q1 to Q4.

### (Overheating Protection of Heater)

In the power supply unit 100, in the heating mode, electric resistance values of the resistor R8, the resistor R9, and the resistor R10 are determined such that the output of the operational amplifier OP2 gets to a low level when the temperature of the first thermistor th1 is equal to or higher than the threshold THD1. When the temperature of the first thermistor th1 is equal to or higher than the threshold THD1 and the output of the operational amplifier OP2 gets to a low level, a low level signal is input to the clear terminal CLR(⁻) of the FF9. As a result, since the negative logic clear terminal CLR(⁻) is enabled and the output of the FF9 is forcibly changed to a low level, the output of the AND gate 10 also gets to a low level, and the booster circuit 11 stops outputting the heating voltage V_{HEAT}. As described above, since the output signal of the operational amplifier OP2 is input to the booster circuit 11 capable of reliably stopping the power supply to the sheet heater HTR, safety when the sheet heater HTR reaches a high temperature may be enhanced.

In order to return the output of the FF9 to a high level, it is necessary for the MCU 6 to re-input a clock signal to the clock terminal CLK of the FF9 (in other words, restart the FF9). That is, even if the temperature of the first thermistor th1 returns to less than the threshold THD1 after the output from the booster circuit 11 is stopped, the output from the booster circuit 11 is not resumed unless the MCU 6 performs the restart processing of the FF9.

It is assumed that a cause of the temperature of the first thermistor th1 becoming equal to or higher than the threshold THD1 is freezing of the MCU 6. In this case, a high level signal is continuously input to the input terminal A of the AND gate 10, and a clock signal is continuously input to the FF9. Although details will be described later, the aerosol generating device 200 is provided with a restart circuit RBT (see FIG. 12) capable of restarting (resetting) the MCU 6 by the user operating the switch BT. When a cause of the protection circuit functioning is freezing of the MCU 6, the MCU 6 is restarted by the user. When the MCU 6 is restarted, the FF9 is restarted. When the MCU 6 is restarted, the signal input to the input terminal A of the AND gate 10 gets to a low level. Further, since the switch Q6 is in an OFF state at a timing when the MCU 6 is restarted, a potential of the signal of the input terminal B of the AND gate 10 is undefined. Therefore, the output from the booster circuit 11 is not resumed by just restarting the MCU 6. After the MCU 6 is restarted, the operation mode is transitioned to the heating mode by a user operation, and thus the signal input to the input terminal A of the AND gate 10 gets to a high level. Further, by setting the switch Q6 to an ON state, the signal input to the input terminal B of the AND gate 10 gets to a high level. Accordingly, the output from the booster circuit 11 is resumed.

### (Configuration and Operation of Restart Circuit RBT)

FIG. 12 is a circuit diagram showing electronic components related to the restart of the MCU 6 and extracted from the circuit shown in FIG. 9. FIG. 12 shows the restart circuit RBT. The restart circuit RBT includes a voltage dividing circuit including the resistor R3 and the resistor R4, the switch BT, the terminal KEY and the terminal GND of the main connector 20A, the switch Q7, the switch Q9, the charging IC 3, the LDO 4, and the terminal NRST of the debug connector 20E. In the present embodiment, the MCU 6 may be restarted by the restart circuit RBT according to an operation of the switch BT (as an example, a long-press operation) and a command from an external device connected to the debug connector 20E. The MCU 6 is configured to restart when a signal input to the terminal P27 continues to be at a low level for a predetermined time. Further, the charging IC 3 is configured to restart when a signal input to the terminal QON(⁻) continues to be at a low level for a predetermined time.

### (Reset of MCU 6 Using Switch BT)

First, an operation when the MCU 6 is restarted without using the debug connector 20E will be described.

The resistor R3 and the resistor R4 have such resistance values that an output of the voltage dividing circuit including the resistor R3 and the resistor R4 gets to a high level in a state where the switch BT is not pressed down. Since a high level signal is input to the terminal QON(⁻) of the charging IC 3, the charging IC 3 is not reset in this state, and the output of the system power supply voltage V_{SYS} from the output terminal SYS is continued. Since the output of the system power supply voltage V_{SYS} is continued, the output of the system power supply voltage V_{MCU} from the output terminal OUT of the LDO 4 is also continued. Therefore, the MCU 6 continues to operate without stopping. Further, a high level signal is input to the gate terminal of the switch Q7. Therefore, when the USB connection is established (when the bus voltage V_{BUS} is output from the charging IC 3), the switch Q7 gets to an ON state, and as a result, a potential of the gate terminal of the switch Q9 gets to a low level (ground level), and the switch Q9 gets to an OFF state. When the switch Q9 is in an OFF state, a potential of the terminal P27 of the MCU 6 is undefined, so that the MCU 6 is not restarted.

The resistor R3 and the resistor R4 have such resistance values that an output of the voltage dividing circuit including the resistor R3 and the resistor R4 gets to a low level in a state where the switch BT is pressed down. In other words, the resistor R3 and the resistor R4 have such resistance values that a value obtained by dividing the system power supply voltage V_{MCU} gets to a low level. Since a low level signal is input to the terminal QON(⁻) of the charging IC 3, the charging IC 3 stops outputting the system power supply voltage V_{SYS} from the output terminal SYS when this state continues for a predetermined time. When the output of the system power supply voltage V_{SYS} is stopped, the voltage output from the LDO 4 is stopped, the system power supply voltage V_{MCU} is not input to the terminal VDD of the MCU 6, and the MCU 6 is stopped.

Further, a low level signal is input to the gate terminal of the switch Q7. Therefore, when the USB connection is established (when the bus voltage V_{BUS} is output from the charging IC 3), the switch Q7 gets to an OFF state, and as a result, the potential of the gate terminal of the switch Q9 gets to a high level (bus voltage V_{BUS}), and the switch Q9 gets to an ON state. When the switch Q9 gets to an ON state, the potential of the terminal P27 of the MCU 6 gets to a low level (ground level). When the switch BT is continuously pressed down for a predetermined time, a low level signal is input to the terminal P27 of the MCU 6 for a predetermined time, and thus the MCU 6 executes the restart processing. When the press-down of the switch BT ends, the charging IC 3 resumes the output of the system power supply voltage V_{SYS}, so that the system power supply voltage V_{MCU} is input to the terminal VDD of the MCU 6 which is stopped, and the MCU 6 is started up.

### (Reset of MCU 6 Using Debug Connector 20E)

When the MCU 6 is restarted using the debug connector 20E, the USB connection is performed, and then an external device is connected to the debug connector 20E. In this state, if the switch BT is not pressed, the switch Q9 gets to an OFF state, and thus the potential of the terminal P27 of the MCU 6 depends on an input from the external device. Therefore, when an operator operates the external device to input a low-level restart signal to the terminal NRST, the restart signal is continuously input to the terminal P27 for a predetermined time. By receiving the restart signal, the MCU 6 executes the restart processing.

### (Detailed Configuration of Main Substrate 20)

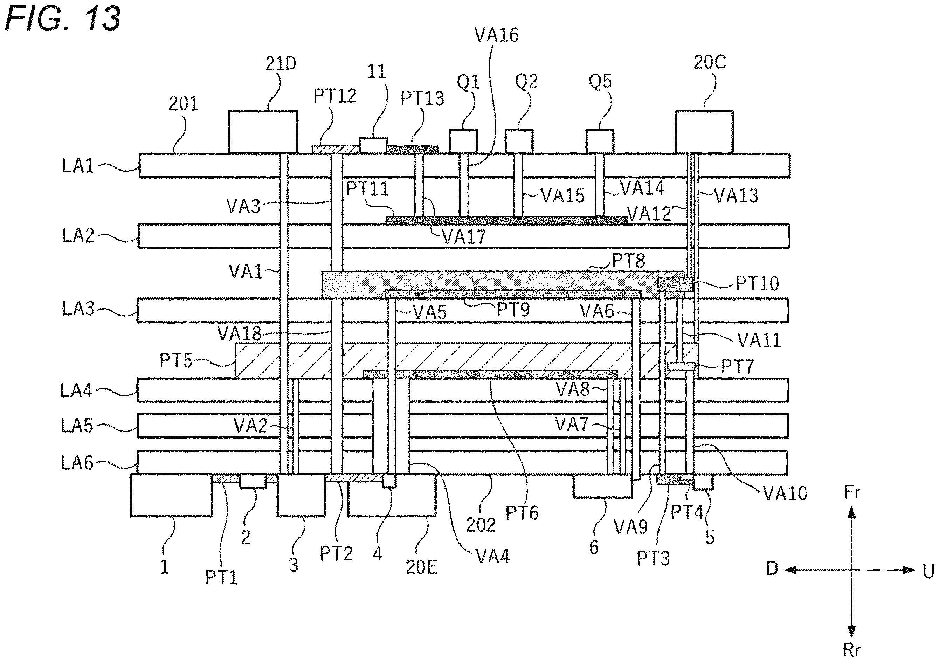

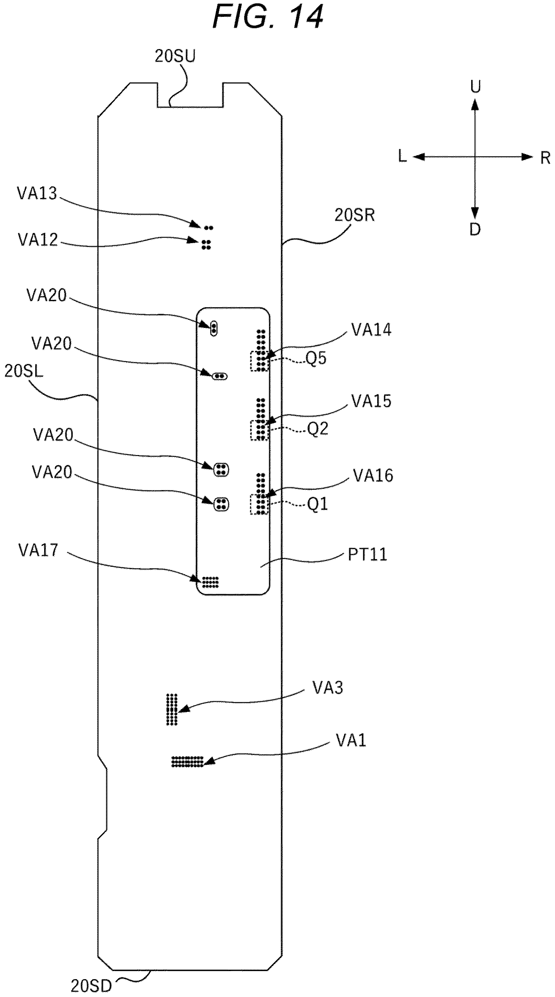

The main substrate 20 has a multi-layer structure, and in the present embodiment, has a six-layer structure. FIG. 13 is a side view of the main substrate 20 as viewed from a right side surface 20SR side. The main substrate 20 includes, in order from a rear side, a sixth layer LA6, a fifth layer LA5 stacked on the sixth layer LA6, a fourth layer LA4 stacked on the fifth layer LA5, a third layer LA3 stacked on the fourth layer LA4, a second layer LA2 stacked on the third layer LA3, and a first layer LA1 stacked on the second layer LA2. A surface of the first layer LA1 on a front side constitutes the front surface 201 of the main substrate 20, and a surface of the sixth layer LA6 on a rear side constitutes the back surface 202 of the main substrate 20. FIG. 14 is a front view of the second layer LA2 as viewed from the front side.

On the surface of the sixth layer LA6 on the rear side, the charging terminal 1, the protection IC 2, the charging IC 3, the LDO 4, the debug connector 20E, the switch Q3 that is not shown, the switch Q4 that is not shown, the booster circuit 5, and the MCU 6 are mounted as electronic components. Further, on the surface of the sixth layer LA6 on the rear side, a conductive pattern PT1 (a conductive pattern through which the bus voltage V_{BUS} flows) that connects the charging terminal 1, the protection IC 2, and the charging IC 3; a conductive pattern PT2 (a conductive pattern through which the system power supply voltage V_{SYS} flows) that connects the output terminal SYS of the charging IC 3 and the input terminal IN of the LDO 4; a conductive pattern PT3 (a conductive pattern through which the OLED voltage V_{OLED} flows) that is connected to the output terminal VOUT of the booster circuit 5; and a conductive pattern PT4 (a conductive pattern through which the system power supply voltage V_{SYS} flows) that is connected to the input terminal VIN of the booster circuit 5 are formed as conductive patterns for electrically connecting the electronic components to each other.

On a surface of the fourth layer LA4 on a front side, a conductive pattern PT5 constituting the signal line SL, a conductive pattern PT6 for connecting the debug connector 20E and the MCU 6, and a conductive pattern PT7 for relay are formed.

On a surface of the third layer LA3 on a front side, a conductive pattern PT8 through which the system power supply voltage V_{SYS} flows, a conductive pattern PT9 (a conductive pattern through which the system power supply voltage V_{MCU} flows) that connects the output terminal OUT of the LDO 4 and the terminal VDD of the MCU 6, and a conductive pattern PT10 for relay are formed.

On a surface of the first layer LA1 on a front side, the capacitor C1 that is not shown, the battery connector 21D, the booster circuit 11, the switch Q1, the switch Q2, the switch Q5, and the OLED connector 20C are mounted as electronic components. Further, on the surface of the first layer LA1 on the front side, a conductive pattern PT12 (a conductive pattern through which the system power supply voltage V_{SYS} flows) that is connected to the input terminal VIN of the booster circuit 11, and a conductive pattern PT13 (a conductive pattern through which the heating voltage V_{HEAT} flows) that is connected to the output terminal VOUT of the booster circuit 11 are formed.

On a surface of the second layer LA2 on a front side, a conductive pattern PT11 (a conductive pattern through which the heating voltage V_{HEAT} flows) that is connected to the conductive pattern PT13 of the first layer LA1 is formed. As shown in FIG. 14, the conductive pattern PT11 has a rectangular shape extending in the upper-lower direction, and has four rounded corners. A width of the conductive pattern PT11 is largest among all the conductive patterns formed on the main substrate 20. In other words, the width of the conductive pattern PT11 is larger than that of a conductive wire pattern having a smallest width among the conductive patterns formed on the first layer LA1. In other words, the width of the conductive pattern PT11 is larger than a width of any of the conductive patterns formed on the first layer LA1. The width of the conductive pattern is a distance along a direction orthogonal to a current flow direction.

The battery connector 21D and the charging IC 3 are connected by a via VA1 penetrating each layer of the main substrate 20. The terminal T3 of the charging IC 3 and the conductive pattern PT5 are connected by a via VA2 penetrating the fourth layer LA4 to the sixth layer LA6. The conductive pattern PT5 and the terminal T3 of the OLED connector 20C are connected by a via VA13 penetrating the first layer LA1 to the third layer LA3. The terminal VCC_R of the OLED connector 20C and the conductive pattern PT10 are connected by a via VA12 penetrating the second layer LA2 and the first layer LA1. The conductive pattern PT10 and the conductive pattern PT3 are connected by a via VA9 penetrating the third layer LA3 to the sixth layer LA6.

The output terminal OUT of the LDO 4 and the conductive pattern PT9 are connected by a via VA5 penetrating the third layer LA3 to the sixth layer LA6. The conductive pattern PT9 and the terminal VDD of the MCU 6 are connected by a via VA6 penetrating the third layer LA3 to the sixth layer LA6.

The terminals T1, T2, and NRST of the debug connector 20E and the conductive pattern PT6 are connected by a via VA4 penetrating the fourth layer LA4 to the sixth layer LA6. The conductive pattern PT6 and the terminals P22, P23, and P27 of the MCU 6 are connected by a via VA8 penetrating the fourth layer LA4 to the sixth layer LA6.

The conductive pattern PT2 and the conductive pattern PT8 are connected by a via VA18 penetrating the third layer LA3 to the sixth layer LA6. The conductive pattern PT8 and the conductive pattern PT12 are connected by a via VA3 penetrating the first layer LA1 and the second layer LA2. The conductive pattern PT8 and the conductive pattern PT7 are connected by a via VA11 penetrating the third layer LA3. The conductive pattern PT7 and the conductive pattern PT4 are connected by a via VA10 penetrating the fourth layer LA4 to the sixth layer LA6.

In the first layer LA1, vias VA14 to VA17 each penetrating the first layer LA1 are formed. The via VA17 connects the conductive pattern PT13 and the conductive pattern PT11. The via VA16 connects the source terminal of the switch Q1 and the conductive pattern PT11. The via VA15 connects the source terminal of the switch Q2 and the conductive pattern PT11. The via VA14 connects the source terminal of the switch Q5 and the conductive pattern PT11. Although not illustrated in FIG. 13, one end of the smoothing capacitor C1 shown in FIG. 9 is connected to the conductive pattern PT13 of the first layer LA1. Due to the presence of the capacitor C1, large electric power (large current) from which a ripple (pulsation) component is removed may flow through the conductive pattern PT11.

As shown in FIG. 14, in the second layer LA2, a via VA20 insulated from the conductive pattern PT11 and penetrating the second layer LA2 is formed in a region inward than an outer peripheral edge of the conductive pattern PT11. The via VA20 connects the electronic component formed in any one of the third layer LA to the sixth layer LA6 and the electronic component formed in the first layer LA1. Further, when viewed in a thickness direction of the main substrate 20 (the front-rear direction of the power supply unit 100), the switch Q1, the switch Q2, and the switch Q5 overlap the via VA14, the via VA15, and the via VA16, respectively. Accordingly, each of conductive patterns for respectively connecting front end surfaces of the via VA14, the via VA15, and the via VA16 to the switch Q1, the switch Q2, and the switch Q5 requires no or only a small area on the first layer LA1. As a result, a front surface of the first layer LA1 may be effectively used.

In the main substrate 20 configured as described above, the conductive pattern PT11 through which the heating voltage V_{HEAT} flows is formed on the second layer LA2 immediately below the first layer LA1, instead of the first layer LA1 on which the booster circuit 11 that generates the heating voltage V_{HEAT}, and many electronic components such as the switches Q1, Q2, Q5, and the capacitor C1 that need to supply the heating voltage V_{HEAT} are mounted and which has a limited surplus space. Further, on the second layer LA2, only the conductive pattern PT11 is present as a conductive pattern for connecting the vias to each other, that is, a conductive pattern that may need an area. As described above, since the conductive pattern PT11 is formed on the second layer LA2 having a large surplus space, the width of the conductive pattern PT11 may be increased sufficiently, and resistance of the conductive pattern PT11 may be reduced. Accordingly, heat and noise generated in the main substrate 20 may be reduced. In addition, by not providing a conductive pattern other than the conductive pattern PT11 on the second layer LA2, the other conductive pattern is less likely to be affected by heat or noise generated in the conductive pattern PT11, and an operation of the power supply unit 100 may be more stable.

Further, the conductive pattern PT11 has a rectangular shape as shown in FIG. 14. By using the conductive pattern PT11 having such a simple shape, it is possible to reduce not only the width but also a resistance component and an induction component derived from the shape. Accordingly, the heat and noise generated in the conductive pattern PT11 may be further reduced. Further, since the corner portions of the conductive pattern PT11 are rounded, an increase in the resistance component (R component) and the induction component (L component) at the corner portions may be prevented, and the heat and noise generated in the conductive pattern PT11 may be further reduced.

Further, in the region inside the conductive pattern PT11, the via VA20 that is not connected to the conductive pattern PT11 and penetrates the second layer LA2 is provided. As described above, by providing the via VA20 inside the large-area conductive pattern PT11, the number of vias penetrating the second layer LA2 may be increased, and the arrangement of the vias may be devised without significantly impairing the width of the conductive pattern PT11, so that an increase in a size and the number of layers of the main substrate 20 may be prevented.

Further, the second layer LA2 on which the conductive pattern PT11 for large electric power to flow therethrough is formed is disposed closer to the first layer LA1 among the six layers constituting the main substrate 20. Therefore, an influence of heat and noise that may be generated in the conductive pattern PT11 on the electronic components mounted on the sixth layer LA6 and the conductive pattern formed on the fourth layer LA4 may be reduced. In particular, since the MCU 6 which is the most important electronic component may be physically and electrically separated from the conductive pattern PT11, an operation of the MCU 6 may be stabilized.

Further, the second layer LA2 on which the conductive pattern PT11 for large electric power to flow therethrough is formed is not an outermost layer of the main substrate 20. Therefore, most of heat and noise that may be generated in the conductive pattern PT11 may be kept inside the main substrate 20. Accordingly, radiation noise and radiation heat to electronic components and the like that are not mounted on the main substrate 20 may be reduced, and the operation of the power supply unit 100 may be stabilized.

Further, in the main substrate 20, the conductive patterns PT8 and PT9 through which large current does not flow are formed on the third layer LA3, and the conductive patterns PT5 and PT6 through which large current does not flow are formed on the fourth layer LA4. In this way, by forming a plurality of conductive patterns through which large current does not flow on a common layer, an increase in the number of layers of the main substrate 20 may be prevented, and a reduction in size and weight of the main substrate 20 and a reduction in manufacturing cost may be realized. Since the conductive patterns PT5 and PT6 are used for communication, shapes thereof tend to be complicated. Therefore, with respect to the conductive pattern PT5 and the conductive pattern PT6 each of which tends to have such a complicated shape, the conductive pattern PT8 and the conductive pattern PT9 each of which does not have such a complicated shape are provided in different layers, so that a space of each layer may be efficiently used.

Further, the main substrate 20 includes the fifth layer LA5 on which no main conductive pattern is provided. The fifth layer LA5 may be omitted. However, the presence of the fifth layer LA5 makes it possible to prevent external noise that may enter from a sixth layer LA6 side from affecting the fourth layer LA4 to the first layer LA1.

Among the voltages used in the power supply unit 100, a voltage equal to or larger than the heating voltage V_{HEAT} is the OLED voltage V_{OLED}. A current that is based on the OLED voltage V_{OLED} flows from the booster circuit 5 through the conductive pattern PT3, the via VA9, the conductive pattern PT10, and the via VA12 in this order, and is supplied to the OLED connector 20C. The OLED connector 20C and the booster circuit 5 are mounted near an upper end portion of the main substrate 20. According to the configuration, an existence region of the supply path of the OLED voltage V_{OLED} may be narrowed in the upper-lower direction. As a result, the OLED voltage V_{OLED} may be prevented from affecting other electronic components as much as possible.

In the present description, at least the following matters are described. In parentheses, corresponding constituent components and the like in the above-mentioned embodiment are indicated, but the present invention is not limited thereto.
(1) A power supply unit of an aerosol generating device, the power supply unit including:
   a power supply (power supply ba);
   a first switch (switch Q1) configured to adjust electric power to be supplied from the power supply to an atomizer that atomizes an aerosol source; and
   a circuit substrate (main substrate 20) on which the first switch is mounted, in which the circuit substrate includes:
      a first layer (first layer LA1) that is a front layer on which the first switch is mounted,
      a second layer (second layer LA2) that is different from the first layer,
      a first via (via VA16) that penetrates the first layer and is connected to the first switch,
      a second via (via VA17) that penetrates the first layer or the second layer and is spaced apart from the first via, and
      a first conductive pattern (conductive pattern PT11) that is provided on the second layer and connects the first via and the second via.
   In (1), in order to generate a sufficient amount of aerosol from the aerosol source, it is necessary to supply large electric power (large current) to the atomizer. According to (1), by forming the first conductive pattern using the second layer instead of the first layer on which it is difficult to form the first conductive pattern having a large width since the first switch is mounted, large electric power (large current) may flow through the first conductive pattern having a large width. Accordingly, even when a sufficient amount of aerosol is generated, heat and noise generated in the circuit substrate may be reduced.
(2) The power supply unit of an aerosol generating device according to (1), in which
   the first switch overlaps the first via when viewed in a stacking direction of the circuit substrate.
   According to (2), since large electric power (large current) may be directly supplied from the first conductive pattern to the first switch, use efficiency of the first layer is improved, many electronic components may be mounted on the first layer, and conductive patterns having other applications may be formed.
(3) The power supply unit of an aerosol generating device according to (2), further including:
   a second switch (switch Q2) different from the first switch and configured to adjust the electric power supplied from the power supply to the atomizer that atomizes the aerosol source, in which
   the second switch is mounted on the first layer, and
   the circuit substrate further includes a third via (via VA15) that connects the first conductive pattern and the second switch.
   According to (3), even when a plurality of switches are used to allow a higher level control on the power supply to the atomizer, large electric power (large current) may be supplied by the first conductive pattern having a large width. Accordingly, the heat and noise generated in the circuit substrate may be reduced while controlling the power supply to the atomizer at a higher level.
(4) The power supply unit of an aerosol generating device according to any one of (1) to (3), further including:
   a boosting converter (booster circuit 11) mounted on the first layer, in which
   an output voltage of the power supply boosted by the boosting converter is supplied to the atomizer.
   According to (4), large electric power (large current) further increased by being boosted by the boosting converter may be supplied to the atomizer, so that a sufficient amount of aerosol may be generated.
(5) The power supply unit of an aerosol generating device according to (4), in which
   an output terminal (terminal VOUT) of the boosting converter is connected to the first conductive pattern via the second via, and
   an output voltage of the power supply boosted by the boosting converter is supplied to the first conductive pattern via the second via.
   According to (5), since the large electric power (large current) further increased by being boosted by the boosting converter may be supplied to the first conductive pattern having a large width, the heat and noise generated in the circuit substrate may be reduced.
(6) The power supply unit of an aerosol generating device according to (5), further including:
   a smoothing capacitor (capacitor C1) connected between the output terminal of the boosting converter and the second via and mounted on the first layer.
   According to (6), since large electric power (large current) from which a ripple (pulsation) component is removed by the smoothing capacitor may flow through the first conductive pattern, the heat and noise generated in the first conductive pattern may be further reduced.
(7) The power supply unit of an aerosol generating device according to any one of (1) to (6), in which
   a width of the first conductive pattern is larger than that of a conductive wire pattern having a smallest width among conductive patterns formed on the first layer.
   According to (7), since the width of the first conductive pattern may be increased, the heat and noise generated in the circuit substrate may be reduced.
(8) The power supply unit of an aerosol generating device according to any one of (1) to (6), in which
   a width of the first conductive pattern is larger than a width of any of conductive patterns formed on the first layer.
   According to (8), since the width of the first conductive pattern may be increased, the heat and noise generated in the circuit substrate may be reduced.
(9) The power supply unit of an aerosol generating device according to (7) or (8), in which
   the first conductive pattern has a rectangular shape.
   In a conductive pattern having a complicated shape, a resistance component (R component) and an induction component (L component) of the conductive pattern itself tend to increase. According to (9), by using the first conductive pattern having a simple shape, it is possible to reduce not only the width but also the resistance component and the induction component derived from the shape. Accordingly, the heat and noise generated in the first conductive pattern may be further reduced.
(10) The power supply unit of an aerosol generating device according to (9), in which corners of the first conductive pattern are rounded.
   The resistance component (R component) and the induction component (L component) tend to increase at a corner or an angle having an acute angle or an angle close thereto in the conductive pattern. According to (10), by using the conductive pattern having a shape with rounded corners, the heat and noise generated in the first conductive pattern may be further reduced.
(11) The power supply unit of an aerosol generating device according to any one of (1) to (10), in which
   a conductive pattern formed on the second layer and connecting the vias is only the first conductive pattern.
   According to (11), since not only an area of the second layer may be more effectively utilized to make the first conductive pattern thicker, but also other conductive patterns are less likely to be affected by the heat and noise generated in the first conductive pattern, the operation of the aerosol generating device may be more stable.
(12) The power supply unit of an aerosol generating device according to (11), in which
   the circuit substrate further includes a fourth via (via VA1, via VA3, via VA12, via VA13, via VA20) that is not connected to the first conductive pattern and penetrates the second layer.
   According to (12), signals and electric power for other purposes may be supplied to other layers and electronic components via the second layer, so that a volume of the substrate may be more effectively utilized. Accordingly, an increase in size and the number of layers of the circuit substrate may be prevented.
(13) The power supply unit of an aerosol generating device according to (12), in which
   the second layer includes a region insulated from the first conductive pattern and provided on an inner side of the first conductive pattern when viewed in a stacking direction of the circuit substrate, and
   the fourth via (via VA20) penetrates the region.
   According to (13), since the number of vias penetrating the second layer may be increased or the arrangement of the vias may be devised without significantly impairing the width of the first conductive pattern, an increase in size and the number of layers of the circuit substrate may be prevented.
(14) The power supply unit of an aerosol generating device according to any one of (11) to (13), further including:
   a controller (MCU 6), in which
   the circuit substrate further includes a third layer (fourth layer LA4) which is different from the first layer and the second layer and on which a second conductive pattern (conductive pattern PT5) used for serial communication or parallel communication of the controller is formed.
   According to (14), since the heat and noise generated in the first conductive pattern are less likely to affect the second conductive pattern for parallel communication or serial communication that is susceptible to heat and noise, accuracy of the serial communication or parallel communication and further accuracy of a control using the same are improved.
(15) The power supply unit of an aerosol generating device according to (14), in which
   the circuit substrate further includes a third conductive pattern (conductive pattern PT6) formed on the third layer and used for rewriting contents stored in a storage area of the controller.
   According to (15), since the heat and noise generated in the first conductive pattern are less likely to affect the conductive pattern used for rewriting in the controller, rewriting accuracy of the controller is improved. Further, by forming the second conductive pattern for parallel communication or serial communication and the conductive pattern for rewriting in the controller, which are less likely to affect each other, in the same layer, an increase in the number of layers of the circuit substrate may be prevented while stabilizing the operation of the aerosol generating device.
(16) The power supply unit of an aerosol generating device according to (14) or (15), in which
   the circuit substrate further includes a fourth layer (third layer LA3) located between the second layer and the third layer.
   According to (16), since physical and electrical distances between the first conductive pattern and another conductive pattern that is susceptible to heat and noise generated in the first conductive pattern may be increased, the operation of the aerosol generating device is stabilized.
(17) The power supply unit of an aerosol generating device according to any one of (1) to (16), in which
   the circuit substrate further includes another layer (sixth layer LA6) that is provided on a side opposite to the first layer and that is a back layer, and
   the other layer is different from the second layer.
   According to (17), since the second layer on which the first conductive pattern is formed is not a front layer of the circuit substrate, most of the heat and noise that may be generated in the first conductive pattern may be kept inside the circuit substrate. Accordingly, radiation noise and radiation heat to electronic components and the like that are not mounted on the circuit substrate are reduced, and the operation of the aerosol generating device is stabilized.
(18) The power supply unit of an aerosol generating device according to (17), further including:
   an electronic component (MCU 6, debug connector 20E, charging terminal 1, charging IC 3, switch Q3, switch Q4, boosting circuit) mounted on the other layer.
   According to (18), by performing mounting on two surfaces of the circuit substrate, more electronic components may be mounted on the circuit substrate. Accordingly, the aerosol generating device may be highly functional.
(19) The power supply unit of an aerosol generating device according to (17) or (18), in which
   the second layer is closer to the first layer than the other layer is when viewed in a thickness direction of the circuit substrate.
   According to (19), since the region in the circuit substrate through which the large electric power (large current) flows is limited to being disposed on a first layer side, the heat and noise that may be generated in the first conductive pattern are less likely to affect electronic components and other conductive patterns mounted on other layers.
(20) The power supply unit of an aerosol generating device according to (19), further including:
   a controller (MCU 6) mounted on the other layer.
   According to (20), since the controller which is a most important electronic component may be physically and electrically separated from the first conductive pattern, which may be a heat source or a noise source, the controller continues to operate normally.
(21) The power supply unit of an aerosol generating device according to any one of (17) to (20), in which
   the second layer is a layer immediately below the first layer.
   According to (21), since the region in the circuit substrate through which the large electric power (large current) flows is limited to being disposed on the first layer side, the heat and noise that may be generated in the first conductive pattern are less likely to affect electronic components and other conductive patterns mounted on other layers.

### REFERENCE SIGNS LIST

100: power supply unit
20: main substrate
LA1: first layer
LA2: second layer
LA3: third layer
LA4: fourth layer
LA5: fifth layer
LA6: sixth layer
VA1 to VA17, VA20: via
PT1 to PT13: conductive pattern
Q1 to Q5: switch

## Claims

1. A power supply unit of an aerosol generating device, the power supply unit comprising:
a power supply;
a first switch configured to adjust electric power to be supplied from the power supply to an atomizer that atomizes an aerosol source; and
a circuit substrate on which the first switch is mounted, wherein
the circuit substrate includes:
a first layer that is a front layer on which the first switch is mounted,
a second layer that is different from the first layer,
a first via that penetrates the first layer and is connected to the first switch,
a second via that penetrates the first layer or the second layer and is spaced apart from the first via, and
a first conductive pattern that is provided on the second layer and connects the first via and the second via.

2. The power supply unit of an aerosol generating device according to claim 1, wherein
the first switch overlaps the first via when viewed in a stacking direction of the circuit substrate.

3. The power supply unit of an aerosol generating device according to claim 2, further comprising:
a second switch different from the first switch and configured to adjust the electric power supplied from the power supply to the atomizer that atomizes the aerosol source, wherein
the second switch is mounted on the first layer, and
the circuit substrate further includes a third via that connects the first conductive pattern and the second switch.

4. The power supply unit of an aerosol generating device according to any one of claims 1 to 3, further comprising:
a boosting converter mounted on the first layer, wherein
an output voltage of the power supply boosted by the boosting converter is supplied to the atomizer.

5. The power supply unit of an aerosol generating device according to claim 4, wherein
an output terminal of the boosting converter is connected to the first conductive pattern via the second via, and
an output voltage of the power supply boosted by the boosting converter is supplied to the first conductive pattern via the second via.

6. The power supply unit of an aerosol generating device according to claim 5, further comprising:
a smoothing capacitor connected between the output terminal of the boosting converter and the second via and mounted on the first layer.

7. The power supply unit of an aerosol generating device according to any one of claims 1 to 6, wherein
a width of the first conductive pattern is larger than that of a conductive wire pattern having a smallest width among conductive patterns formed on the first layer.

8. The power supply unit of an aerosol generating device according to any one of claims 1 to 6, wherein
a width of the first conductive pattern is larger than a width of any of conductive patterns formed on the first layer.

9. The power supply unit of an aerosol generating device according to claim 7 or 8, wherein
the first conductive pattern has a rectangular shape.

10. The power supply unit of an aerosol generating device according to claim 9, wherein corners of the first conductive pattern are rounded.

11. The power supply unit of an aerosol generating device according to any one of claims 1 to 10, wherein
a conductive pattern formed on the second layer and connecting the vias is only the first conductive pattern.

12. The power supply unit of an aerosol generating device according to claim 11, wherein
the circuit substrate further includes a fourth via that is not connected to the first conductive pattern and penetrates the second layer.

13. The power supply unit of an aerosol generating device according to claim 12, wherein
the second layer includes a region insulated from the first conductive pattern and provided on an inner side of the first conductive pattern when viewed in a stacking direction of the circuit substrate, and
the fourth via penetrates the region.

14. The power supply unit of an aerosol generating device according to any one of claims 11 to 13, further comprising:
a controller, wherein
the circuit substrate further includes a third layer which is different from the first layer and the second layer and on which a second conductive pattern used for serial communication or parallel communication of the controller is formed.

15. The power supply unit of an aerosol generating device according to claim 14, wherein
the circuit substrate further includes a third conductive pattern formed on the third layer and used for rewriting contents stored in a storage area of the controller.

16. The power supply unit of an aerosol generating device according to claim 14 or 15, wherein
the circuit substrate further includes a fourth layer located between the second layer and the third layer.

17. The power supply unit of an aerosol generating device according to any one of claims 1 to 16, wherein
the circuit substrate further includes another layer that is provided on a side opposite to the first layer and that is a back layer, and
the other layer is different from the second layer.

18. The power supply unit of an aerosol generating device according to claim 17, further comprising:
an electronic component mounted on the other layer.

19. The power supply unit of an aerosol generating device according to claim 17 or 18, wherein
the second layer is closer to the first layer than the other layer is when viewed in a thickness direction of the circuit substrate.

20. The power supply unit of an aerosol generating device according to claim 19, further comprising:
a controller mounted on the other layer.

21. The power supply unit of an aerosol generating device according to any one of claims 17 to 20, wherein
the second layer is a layer immediately below the first layer.
